Europäisches Patentamt

European Patent Office

Office européen des brevets

(19)

(11) EP 0 464 748 B1

(12) EUROPEAN PATENT SPECIFICATION

(45) Date of publication and mention
of the grant of the patent:
**31.10.2001 Bulletin 2001/44**

(51) Int Cl.$^7$: **G01R 31/36**, H02J 7/14,
G01R 15/00

(21) Application number: **91110879.3**

(22) Date of filing: **01.07.1991**

(54) **Battery condition detecting apparatus**

Vorrichtung zur Erfassung eines Batteriezustandes

Dispositif pour la détection de l'état d'une batterie

(84) Designated Contracting States:
**DE FR GB**

(30) Priority: **02.07.1990 JP 17502390**
**12.10.1990 JP 27484790**
**28.11.1990 JP 33293990**
**18.01.1991 JP 435291**
**11.06.1991 JP 13927091**

(43) Date of publication of application:
**08.01.1992 Bulletin 1992/02**

(73) Proprietor: **DENSO CORPORATION**
**Kariya-City Aichi-Pref. 448 (JP)**

(72) Inventors:
 • **Kato, Hidetoshi**
   **Suzuka-shi (JP)**
 • **Mayumi, Nobuo**
   **Toyohashi-shi (JP)**
 • **Togawa, Masatoshi**
   **Kariya-shi (JP)**
 • **Banzai, Keiichiro**
   **Toyota-shi (JP)**
 • **Sada, Takeshi**
   **Kariya-shi (JP)**
 • **Sato, Hirohide**
   **Toyokawa-shi (JP)**

(74) Representative:
**Pellmann, Hans-Bernd, Dipl.-Ing. et al**
**Patentanwaltsbüro**
**Tiedtke-Bühling-Kinne & Partner**
**Bavariaring 4-6**
**80336 München (DE)**

(56) References cited:
**EP-A- 0 300 537         EP-A- 0 359 237**
**WO-A-89/01169        GB-A- 2 219 864**
**US-A- 4 390 841        US-A- 4 852 540**
**US-A- 4 901 008**

 • **N.T.I.S. TECH NOTES (ELECTROTECHNOLOGY)**
   **no. 1B, January 1985, SPRINGFIELD, USA pages**
   **71 - 72 ROWLETTE '"Fuel Gage" for Electric**
   **Vehicles'**

**Description**

The present invention relates to a battery condition detecting apparatus to correctly grasp conditions of a battery, i.e., capacities thereof, and also a charge control apparatus for an automobile, for setting a charge target value of a battery based on conditions of the battery mounted on the automobile with employment of the battery condition detecting apparatus, and for charging the battery at this target value during the drive operation.

As shown in JP-A-53-127646, as a conventional means for detecting capacities of a battery mounted on a vehicle, with the capacity of the battery obtained from the discharge characteristic while the starter is started, the charge/discharge currents of the battery after this capacity are accumulated, or multiplied.

Thus, when the battery capacity detecting means detects that the capacity of the battery is lowered, it is possible to prevent the battery from being lowered by cutting out a predetermined electric load from the battery. Also, there has been proposed such a method for controlling power generated by the alternator, taking account of the capacities of the battery and the conditions of the vehicle.

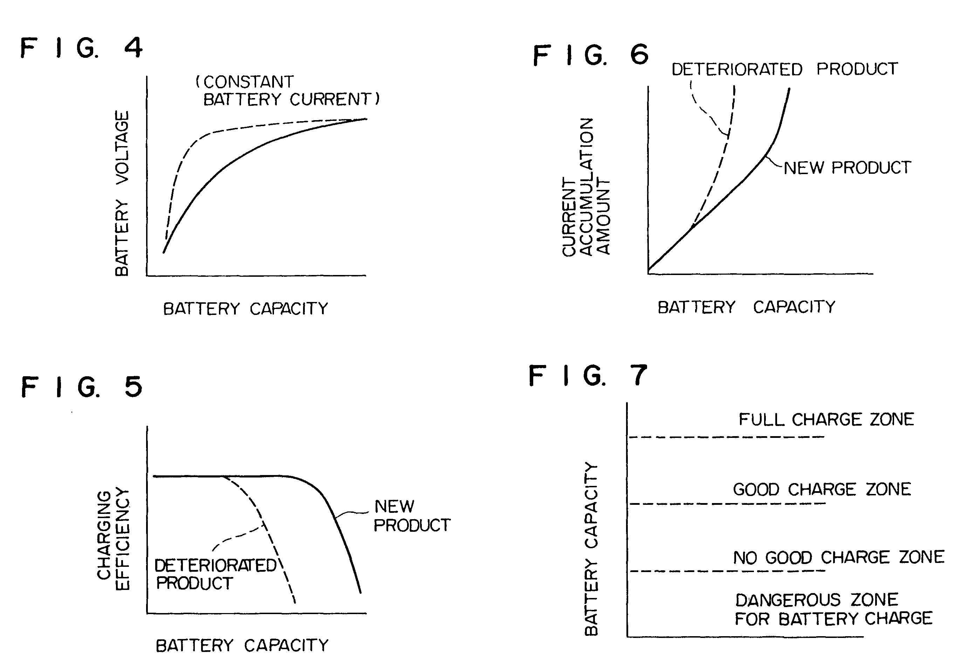

In general, a battery owns a charge characteristic as represented in Fig. 5. That is to say, as indicated by a solid line of this figure, an increase ratio of a capacity to a charge current (referred to as a "charge efficiency") is substantially 100% under such a condition that the capacity of the battery is lower than about 80% of the actual capacity when this battery is a new product. However, if the capacity of the battery becomes higher than about 80% of the actual capacity by being charged, since gassing (such a phenomenon that while the battery is charged and the capacity thereof is increased, the voltage of the electrode is increased; and when this electrode voltage is increased higher than a predetermined value, water contained in the battery fluid is subjected to electrodialysis due to the charge current) may happen to occur, the charge efficiency is gradually lowered. Then, while the battery is deteriorated, a timing at which the gassing phenomenon commences is gradually shortened, namely a timing at which the charge efficiency starts to be lowered is gradually shortened, and also the charge efficiency is rapidly lowered. The capacity at which the battery can be charged (referred to as "a maximum capacity") is reduced and then the capacity cannot be increased to the actual capacity (= maximum capacity of a new battery). In other words, there are differences in the charge characteristics of a new battery and a deteriorated battery. A dot line shown in Fig. 5 indicates one example of the charge characteristic for the deteriorated battery.

Furthermore, a capacity of a battery is also reduced due to a discharge operation. As a consequence, according to the conventional battery condition detecting method, even when lowering the battery capacity may be detected, no detection is made that this detection is caused by either the discharge operation, or the battery deterioration.

Then, to control power generated by the alternator taking account of the conditions of the vehicle, it is absolutely necessary to charge the battery. In case when the battery is deteriorated, most of the charge currents are used for the gassing, so that the battery fluid is reduced, which may cause adverse influences to the lifetime of the battery. There is another problem that although the capacity of the battery is not increase under such a condition that the maximum capacity is lowered and the charge current is continuously supplied to the battery, if the charge operation is continued, lowering the battery fluid caused by the gassing is further increased.

Document WO-A-89/01169 (reflecting the preamble of claims 1 and 16) discloses a battery state of charge indicator for a vehicle starter battery, wherein on the basis of an improved mathematical model, the gassing current within the battery is taken into account. The battery output voltage, the charge/discharge current and the temperature of the battery are periodically measured. The battery current with respect to time is integrated to produce an indication of the net charge taken from the battery. On the basis of the integrated value and the further detected actual conditions of the battery, it can be predicted the charging state of the battery and the current, which can be obtained therefrom. The values representing the actual charging state of the battery are thereafter corrected by taking into account the gassing current flowing inside the battery and forming a part of the entire battery current to more precisely predict the withdrawable charge, which can still be withdrawn from the battery. A starter current is not taken into consideration because a starter current higher than a predetermined value is regarded as negligible since the starting process rarely lasts longer than ten seconds.

Furthermore, document EP-A-0 359 237 deals with an apparatus for displaying the remaining charge of a rechargeable battery, wherein the voltage of the battery is monitored and a control signal is output, when the battery output voltage falls below a predetermined threshold level. During operation of the battery, which has an initial battery capacity, the discharging current is accumulated and an accumulated capacity value is then provided. On the basis of the initial capacity and the accumulated capacity of the battery, the remaining overall capacity can be predicted. The apparatus includes a self-learning function which changes a stored variable, such as the battery capacity, based on actual battery conditions.

Document US-A-4 852 540 discloses a high-efficiency charging and regulating system for a vehicle, wherein an alternator provides a charging current which is regulated by a voltage regulating circuit for properly charging the battery. The charging and regulating circuit becomes active at relatively low engine rotational speeds, and when the battery is disconnected from the alternator, the charging and regulating system shuts down, so that excessively high voltages occurring at the alternator coils provided by high engine rotational speeds, are not connected through the vehicle electrical system to any other electric device driven by the alternator.

It is therefore a primary object of the present invention to provide a battery condition detecting apparatus capable of recognizing that a battery is deteriorated due to variations of charge characteristics thereof.

It is a secondary object of the present invention to provide a charge control apparatus for an automobile, capable of charging a battery with extremely suppressing an amount of gassing by employing this battery condition detecting apparatus.

The above objects are achieved by a battery condition detecting apparatus and a method of detecting a battery condition as recited in the appended independent claims 1 and 16, respectively.

In accordance with the above-described battery condition detecting apparatus and method, the first battery capacity which has been detected based upon the discharge characteristic when the battery discharges at a predetermined current, is compared with the second battery capacity which has been detected based on the accumulated value of the battery charge/discharge currents, and then the smaller capacity is set to the initial capacity. As a result of this comparison, if the second battery capacity is higher than the first battery capacity, it may be detected that the second battery capacity becomes higher than the actual capacity due to an occurrence of gassing. As previously stated, the occurrence of gassing is caused by the variations in the charge efficiency due to the battery deterioration. In case that such a comparison result is obtained that the second battery capacity is greater than the first battery capacity, since the difference between the first and second battery capacities is also changed in accordance with the variations in the charge efficiency, it is possible to judge based on this difference a degree of battery deterioration.

Also, in accordance with the charge control apparatus employing the above-explained battery condition detecting apparatus and the corresponding method, since based on the gassing amount obtained by comparing the first battery capacity with the second battery capacity, the charge target value of the battery is set, the battery is charged with extremely suppressing the occurrence of gassing. As a consequence, since the over-charge of the battery may be prevented, it is possible to prevent shortening the lifetime of the battery. Also, such a control is performed that the difference between the first and second battery capacities becomes small during the comparison, and the first and second battery capacities obtained by the different detecting means have the substantially equal values with each other. In other words, these first and second battery capacity detecting means detect the correct battery capacity. As a result, more correct battery capacity can be recognized.

These and other objects and advantages of the present invention will become apparent by reference to the following description and accompanying drawings, wherein;

Fig. 1 is a diagram for representing an overall arrangement of an automobile charge control apparatus employing a battery condition detecting apparatus according to first and second preferred embodiments of the present invention;

Fig. 2 is a schematic block diagram for representing a process function of the control circuit shown in Fig. 1;

Fig. 3 is a flow chart for representing the process performed in the control circuit according to the first preferred embodiment;

Fig. 4 is a characteristic diagram for showing a characteristic of a battery voltage with respect to a battery capacity when a battery is discharged;

Fig. 5 is a characteristic diagram for showing a characteristic of a charging efficiency with respect to a battery capacity when a battery is charged;

Fig. 6 is a characteristic diagram for indicating an accumulation amount of a battery charge current with respect to a battery capacity when a battery is charged;

Fig. 7 is a battery condition representing diagram for representing the battery conditions as four states, depending upon its capacity;

Fig. 8 is a flow chart for representing a detailed process of the step 30 shown in Fig. 3, more in detail;

Fig. 9 is a flow chart for showing a detailed process of the step 40 shown in Fig. 3, more in detail;

Fig. 10 is a schematic block diagram for showing the alternator controlling unit 9f indicated in Fig. 2 and the alternator 5 represented in Fig. 1;

Fig. 11 is a flow chart for showing the process effected by the conducting ratio controlling circuit $9f_3$ during the normal drive;

Fig. 12 is a flow chart for representing the process executed by the conducting ratio controlling circuit $9f_3$ during the idle drive;

Fig. 13 is a flow chart for representing the process effected by the control circuit 9 when an automobile is accelerated, decelerated, and also driven on a down slope;

Fig. 14 is a flow chart for representing the process executed by the control circuit according to the second preferred embodiment;

Fig. 15 is a flow chart for representing the process of the step 70 shown in Fig. 14, more in detail;

Fig. 16 is a characteristic diagram for representing a transition of a battery capacity;

Fig. 17 is a characteristic diagram for analogously representing a characteristic of a charging efficiency with respect to a battery capacity when a battery is charged;

Fig. 18 is a characteristic diagram for representing a charging efficiency with respect to a battery capacity when a battery is charged;

Figs. 19 to 21 are explanatory diagrams for showing an arrangement of a current detecting apparatus according to a preferred embodiment of the present invention, in which Fig. 19 is a circuit diagram of the current detecting apparatus; Figs. 20 and 21 are characteristic diagrams of the current detecting apparatus; and,

Fig. 22 represents an overall construction of an automobile charging control apparatus employing the current detecting apparatus shown in Fig. 19.

First Preferred Embodiment

A description will now be made of an automobile charge control apparatus into which a battery condition detecting apparatus according to a first preferred embodiment of the present invention.

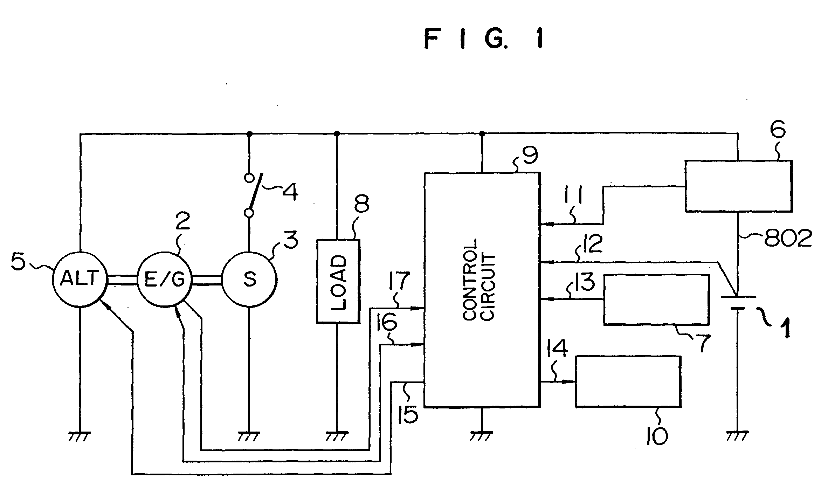

In Fig. 1, reference numeral 1 indicates a battery mounted on an automobile; reference numeral 2 denotes an engine for driving the automobile, reference numeral 3 represents a starter for starting the engine; reference numeral 4 indicates a starter switch for commencing the start. As is well known, by turning on the starter switch 4 so as to supply power from the battery 1 to the starter 3, this starter 3 is rotated and the engine 2 starts.

Reference numeral 5 indicates an alternator driven by the engine 2 via a belt and a pulley (both are not shown), for charging the battery 1 and also supplying the power to an electric load 8 such as a lamp, a blower motor and defogger. Reference numeral 6 indicates a current detector for detecting charge/discharge current of the battery 1; reference numeral 7 denotes a temperature detector for detecting temperature of the battery 1; reference numeral 9 indicates a control circuit employing a microcomputer, for detecting conditions of the engine 2, and voltages, currents and temperature of the battery 1 in order to control revolution number of the engine 2 and AC power of the alternator 5, and furthermore for detecting life of the battery 1 so as to display the life by way of a display device 10. As to controls effeced in the control circuit 9, (I) detection of a battery capacity; (II) setting of a charge target value for the battery; and (III) charge control of the battery during drive conditions will now be described in this order.

(I). Detection of Battery Capacity

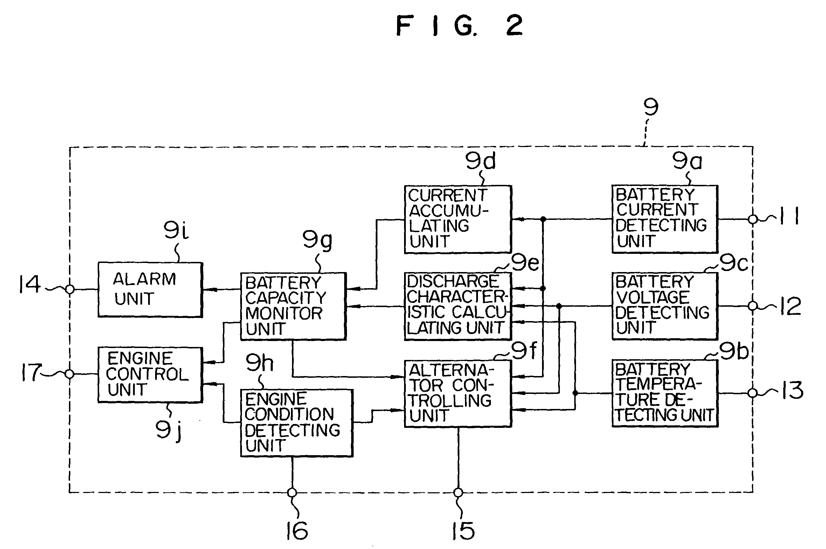

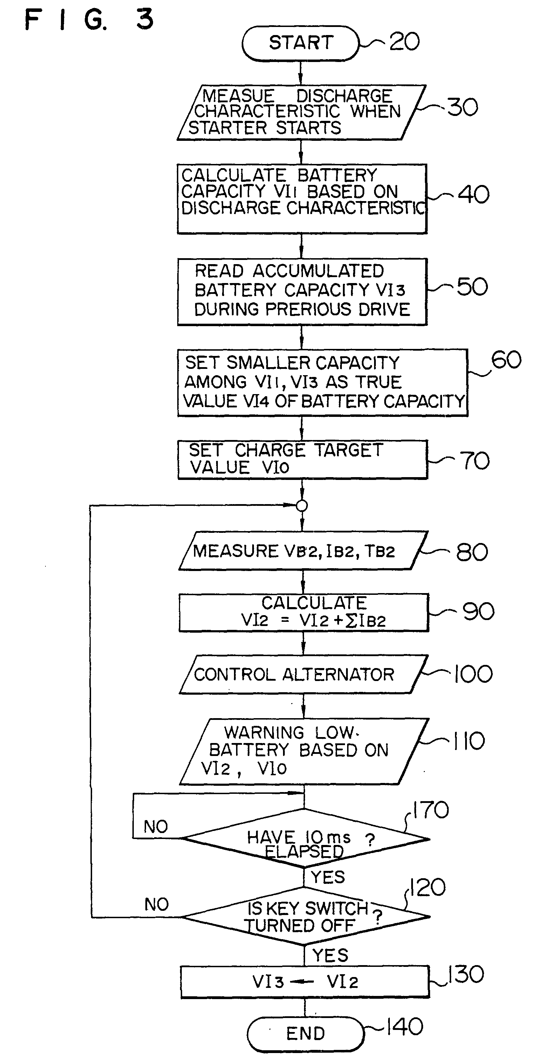

Fig. 2 is a schematic block diagram for representing process functions performed in the control circuit 9, and Fig. 3 is a flow chart for representing the controls effected in this control circuit 9. A description of the battery capacity detection will now be made based on these figures.

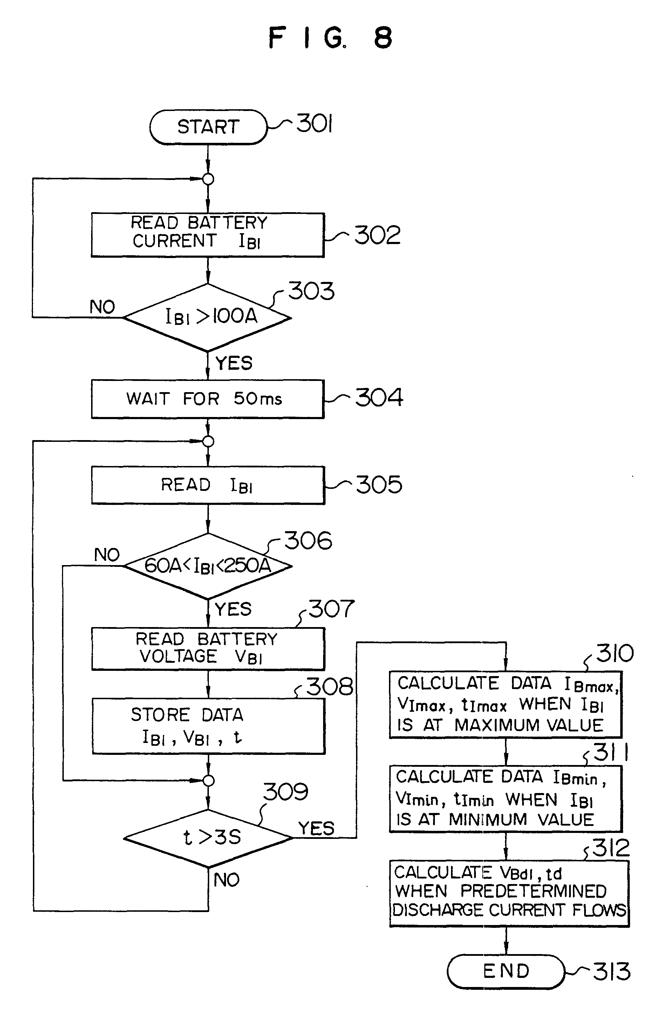

In the flowchart shown in Fig. 3, the starter switch 4 is turned on at a step 20 whereby the starter 3 starts. Next, the discharge characteristic when the starter starts is measured at a step 30. This operation will now be explained in accordance with a flow chart to Fig. 8.

At a step 302, a discharge current "$I_{B1}$" of the battery 1 which has been detected by the current detector 6 is read from the current detecting unit 9a. At a step 303, when the discharge current $I_{B1}$ becomes higher than 100 A, confirmation is made that the starter 3 starts. As a step 304, a waiting process is performed for, e.g., 50 ms after the confirmation is made that the starter 3 starts at the above-described step 303. This waiting process is required, since a large current rapidly flows just after the starter 3 starts and then noise may happen to occur, whereby no adverse influence caused by the noise is made. After the adverse influence caused by the noise has been eliminated at the step 304, the discharge current "$I_{B1}$" of the battery 1 is read from the current detecting unit 9a at a step 305.

Then, at a step 306 if the discharge current $I_{B1}$ which has been read at the step 305 is present within a range from 80A to 250A, a judgement is made that the starter 3 is under operation. When it is judged that the starter 3 is under operation at the step 306, a voltage "$V_{B1}$" of the battery 1 is read from the voltage detecting unit 9c at a step 307. It should be noted that since the above-described range of the discharge current has been set under such a judgement that when the starter 3 is under operation and the engine 2 is not yet started, the current having 60A to 250A flows through the starter 3, this range is not limited thereto.

Subsequently, at a step 308, the above-described discharge current $I_{B1}$, voltage $V_{B1}$ and time "t" of the battery 1 are stored into the discharge characteristic calculating unit 9e functioning as a first means for detecting a battery capacity. At a step 309, when three seconds have elapsed after the starter 3 starts (normally, this time has been set to a large value, taking account of such a fact that only one second will pass from starting the starter 3 until the engine starts), the operations as defined from the above-described steps 305 to 308 are interrupted. If three seconds have not yet elapsed after the starter 3 starts, the process is again returned to a step 305. At this time, the operations as defined from the steps 305 to 309 are performed, namely the discharge current $I_{B1}$ and voltage $V_{B1}$ when the starter 3 is under operation are needed and the storage operation is repeated at a interval of 25 ms, and the discharge current

$I_{B1}$ and voltage $V_{B1}$ corresponding to the time "t" at this time are stored. It should be noted that the discharge characteristic calculating unit 9e continuously stores 10 pieces of new data.

Then, at a step 306, when it is judged that the discharge current becomes belower than 60A and the engine 2 starts, the operations as defined by the steps except for the steps 307 and 308 are repeated, and after three seconds have elapsed when the starter starts, the process at the step 309 is advanced to a step 310. At the step 310, a maximum value $I_{Bmax}$ of the discharge current $I_{B1}$ of the battery 1, the voltage $V_{B1}$ and time "t" which are read at the same time with this maximum value $I_{Bmax}$ are calculated as $V_{Imax}$ and $t_{tmax}$ based on the data stored at the step 308. At the next step 311, conversely, a minimum value $I_{Bmin}$ of the discharge current $I_{B1}$, and the voltage $V_{B1}$ and time "t" which are read not the same time with this minimum value $I_{Bmin}$ are calculated as $V_{tmin}$ and $t_{tmin}$, respectively. At a step 312, to a graphic representation where an abscissa indicates the discharge current $I_{B1}$ and an ordinate represents the voltage $V_{B1}$, the maximum value $I_{Bmax}$ of the discharge current which have been calculated at the steps 310 and 311, a coordinate determined by the voltage $V_{Imax}$ at this time, the minimum value $I_{Bmin}$ of the discharge current and a coordiante determined by the voltage $V_{Imin}$ at this time are plotted based upon these data, and a characteristic diagram where these values are connected by a straight line is drawn. Next, based upon this characteristic diagram, the voltage $V_{B1}$ when the discharge current $I_{B1}$ is equal to 150A is calculated as a capacity detection voltage $V_{Bd1}$. The time "t" defined from the commencement of the starter until the detection of the above-described voltage $V_{Bd1}$ is recognized as a capacity detection time "td" by averaging the times $t_{Imax}$ and $t_{Imin}$ calculated at the steps 310 and 311. It should be noted that the value of the discharge current $I_{B1}$ for determining the first capacity detection voltage $V_{Bd1}$ is not limited to 150A.

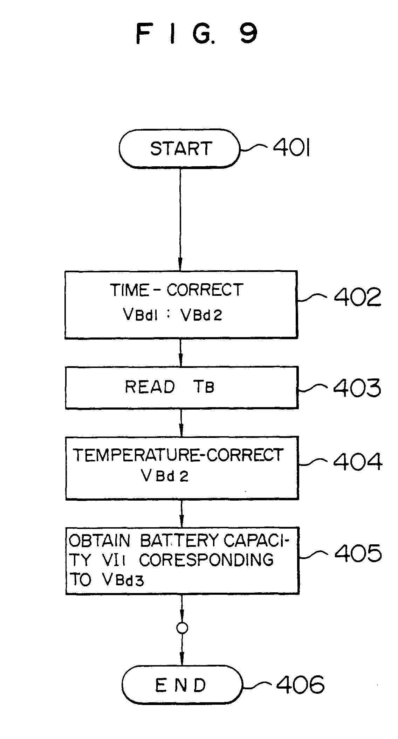

The detected first capacity detection voltage $V_{B41}$ is corrected due to the following reasons as shown in Fig. 9. That is to say, the voltage of the battery 1 when discharges is lowered in accordance with a lapse of time and represents a stable voltage value after approximately five seconds have passed from the commencement of the battery discharge. To the contrary, as stated above, the engine 2 is normally started by driving the starter 3 within one second. The measurement value of the battery voltage when the starter 3 starts, namely the first capacity detection voltage $V_{Bd1}$ measured in the above-described manner indicates such a voltage higher than the stable voltage. Then, a relationship between the discharge time and voltage of the battery characteristics is previously obtained, and at a step 402, a shift "$\Delta V$" between the first capacity detection voltage $V_{Bd1}$ determined by the discharge current while driving the starter 3 and the stable voltage which is obtained after five seconds have passed when the starter 3 starts, is subtracted from the first capacity detection voltage $V_{Bd1}$ for correction purpose. With such a correction, a more correct voltage of the battery 1 when the battery 1 discharges at 150A may be obtained, which will be referred to as a "second capacity detection voltage $V_{Bd2}$".

Furthermore, since the battery voltage owns a temperature characteristic, a battery temperature $T_B$ detected by the battery temperature detector 7 is inputted into the battery temperature detecting unit 9b at a step 403 and thus the second capacity detection voltage $V_{Bd2}$ is corrected in accordance with the battery temperature $T_B$ at a step 404. With this correction, a further more correct voltage of the battery 1 may be obtained which will be referred to as a third capacity detection voltage "$V_{Bd3}$".

Next, at a step 405, a first battery capacity $VI_1$ when the starter 3 is driven is obtained from the third capacity detection voltage $V_{Bd3}$, which will now be explained. In Fig. 4, a solid line indicates a characteristic diagram for representing a relationship between battery voltages and battery capacities under such a condition that the battery 1 discharges at a predetermined current for a predetermined time period, and also there are no electrolyte stratification of the specific gravity of the battery fluid and polarization just after the battery is charged. As represented in this drawing, in case of a small battery capacity, the battery voltage becomes low. Then, this characteristic has been stored in the discharge characteristic calculation unit 9e.

Based upon this characteristic diagram, a decision is made of a capacity of the battery 1 when the starter 3 is driven (will be referred to as a "first battery capacity") with employment of the third capacity detection voltage $V_{Bd3}$ which has been obtained as in the above-described manner.

It should be noted that if a capacity of the battery 1 is unknown due to such a fact that the previous drive corresponds to a first drive, or the battery 1 has been replaced by a new product before the previous drive although this drive does not correspond to the first drive, the battery capacity monitor unit 9g functioning as an initial capacity setting means will set the above-described first battery capacity $VI_1$ as an initial capacity. The current accumulating unit 9d accumulates the charge/discharge currents of the battery 1 after the engine 2 starts, which have been detected by the current detector 6 and read into the battery current detecting unit 9a. The battery capacity monitor unit 9g functioning also as a second battery detecting means detects a second battery capacity $VI_2$ during the drive by adding the accumulated value of the above-described charge/discharge currents to the initial capacity. Then, the battery memory monitor unit 9g stores therein the last value of the second battery capacity $VI_2$, namely the capacity value obtained when the engine is stopped as a third battery capacity $VI_3$.

Assuming now that the third battery capacity $VI_3$ has been stored in the battery capacity monitor unit 9g during the present drive, namely when the engine is started at this time to drive the automobile, a description will be made as follows.

At a step 50 of the flowchart shown in Fig. 3, this third battery capacity $VI_3$ is read out. At a step 60, the above-described first battery capacity $VI_1$ detected when the starter 3 is driven is compared with the third battery capacity $VI_3$ (namely, the second battery capacity just before the first battery capacity $VI_1$ is detected) by the battery capacity monitor unit 9g, whereby a smaller value is regarded as true value and set as the initial capacity $VI_4$. Normally, if the battery condition is good, the above-described first battery capacity $VI_1$ is substantially equal to the third battery capacity $VI_3$. As a consequence, either the first or third battery capacity $VI_1$ or $VI_3$ may be employed. However, since there are the following cases, the smaller battery capacity among these first and third battery capacities $VI_1$ and $VI_3$ is employed.

In the first case, the first battery capacity $VI_1$ is larger than the third battery capacity $VI_3$ by a predetermined value. If such a phenomenon that concentration of the battery liquid near the electrode becomes high just after the specific gravity of the battery liquid becomes electrolyte stratification or the battery is charged (will be referred to as a "polarization") happens to occur, the voltage characteristic with respect to the capacity is indicated by a dot line shown in Fig. 4. In other words, when either electrolyte stratification, or polarization happens to occur, the resultant battery voltage becomes higher than the normal battery voltage. As a result, if either electrolyte stratification, or polarization happens to occur when the first battery capacity is detected, the above-described capacity detection voltage higher than that during the normal condition is detected, and the first battery capacity $VI_1$ becomes larger than the true capacity and the third battery capacity $VI_3$. As a consequence, a judgement is made that the third battery capacity $VI_3$ is analogous to the true capacity, which will be set as the initial capacity.

Secondly, it is another case that the third battery capacity $VI_3$ is higher than the first battery capacity $VI_1$ by a predetermined value. This corresponds to such a case that "gassing" happens to occur, as previously described. When the gassing happens to occur, the accumulated value of the battery charge/ discharge currents corresponds to a value obtained by accumulating the charge currents used in the gassing, based on the detection of the second battery capacity $VI_2$, and the second battery capacity $VI_2$ higher than the true capacity is detected. Therefore, the third battery capacity $VI_3$ corresponding to the final value in the higher second battery capacity $VI_2$ becomes higher than the true capacity and the first battery capacity $VI_1$. Furthermore, when the battery becomes deteriorated, since the charging efficiency is quickly lowered, the third battery capacity $VI_3$ becomes greater than that of the new product. As a result, in this case, it is judged that the first battery capacity $VI_1$ is analogous to the true capacity, which will be set as the initial capacity.

It should be understood that with regard to the above-described electrolyte stratification, since bubbles may be produced from the electrode in the gassing and the battery fluid is mixed with each other by the bubbles, it is rather difficult that both the electrolyte stratification and the gassing simultaneously occur. Thus, since the first and third battery capacities $VI_1$ and $VI_3$ do not commonly become large, as previously described, the correct battery capacity may be obtained by employing the smaller value.

(II). Setting Target Charging Value of Battery

Next, at a step 70 shown in Fig. 3, a target charging value (will be referred to as "an upper limit capacity") $VI_0$ of the battery 1 is determined during drive based upon the initial capacity.

For instance, when the first battery capacity $VI_1$ is greater than the third battery capacity $VI_3$, as previously described, the third battery capacity $VI_3$ is set as the initial capacity and the upper limit value $VI_0$ will be set as given by equation (1):

$$VI_0 = VI_3 + A \qquad (1)$$

Here, the real capacity of the battery 1 which has been employed in the present invention is 27 Ah, and as represented in Fig. 7, the conditions of the battery 1 are subdivided into four zones such as a dangerous condition where its capacity is below 9 Ah; a no good condition where its capacity is greater than 9 Ah and smaller than 18 Ah; a good condition where its capacity is greater than 18 Ah and lower than 25 Ah; and also a full charge condition where its capacity is higher than 25 Ah. Then, an increase value "A" for the battery capacity is set, as represented in a table 1, depending upon such a condition to which zone, the initial capacity $VI_4$ belongs.

Table 1

| charge condition | full charge | good | no good | dangerous |
|---|---|---|---|---|
| A [Ah] | 2 | 5 | 10 | 15 |

As indicated in the above table 1, the reason why the capacity increase value "A" has been set is as follows:

When the battery 1 is under the dangerous condition, as previously described, the battery is charged as much as possible in order to control the alternator, taking account of the conditions of the automobile, whereby the battery capacity should be increased (this is similar to such a case that the battery 1 is under other three conditions). However, since the battery 1 might be deteriorated and thus the capacity thereof might be lowered, the gassing amount should also be considered. Thus, to maintain at least 50% of the real capacity, namely 13.5 Ah, for instance, the battery capacity is set to 15 Ah. When the battery 1 is under the no good condition, the charge operation should be performed as in the dangerous condition. For instance, also in such a case that the initial capacity corresponds to the minimum capacity of 9 Ah indicative of the no good condition, the battery condition is set to 10 Ah in order that the battery may be recovered until the good condition. When the battery 1 is under either the good condition, or the full charge condition, the battery capacity is set to 5 Ah or 2 Ah so as to control the above described alternator.

Then, if the third battery capacity $VI_3$ is higher than the first battery capacity $VI_1$, the first battery capacity $VI_1$ is set as the initial capacity. In this case, as previously started, it may be conceived that the gassing occurs. The upper limit value $VI_0$ is corrected based upon a correction value "B" by the following equations (2) to (4) in response to the gassing amount thereof:

$$VI_0 = VI_1 + A - B \tag{2}$$

$$B = \alpha(VI_3 - VI_1) \tag{3}$$

$$\alpha = 0.8 \tag{4}.$$

The correction value "B" is set so as to reduce the increase value of the battery capacity by 80% of this gassing amount in total based upon a difference between the third battery capacity $VI_3$ and the first battery capacity $VI_1$, namely the gassing amount during the previous driving operation. Therefore, the battery 1 is charged in such a manner that the capacity thereof is increased from the capacity when the starter 3 is started until the upper limit value $VI_0$. The upper limit value $VI_0$ is increased every time the automobile is driven. If the battery 1 employed in this automobile becomes deteriorated, a predetermined amount of gassing may be produced, and the increased value in the upper limit value $VI_0$ is reduced. When the increased amount of the upper limit value $VI_0$ is reduced, since the gassing amount is also lowered, the upper limit value $VI_0$ is again increased. Then the battery 1 is charged by repeating these operations and the driving operation, while suppressing the gassing.

It should be noted that to reduce the increased value of the above-described upper limit value $VI_0$ as much as possible and to furthermore suppress the gassing amount, for instance, a means for storing therein a value of the correction value "B" is employed, when such a condition that the third battery capacity $VI_3$ becomes higher than the first battery capacity $VI_1$ is continued, the previous correction value $B_0$ is compared with the present correction value $B_1$, so that the larger value among them may be employed as the present correction value "B".

(III). Control for Battery Charging Operation During Drive

At a step 80, the charge/discharge current $I_{B2}$, voltage $V_{B2}$ and temperature $T_{B2}$ of the battery 1 during the drive operation of the automobile are read; at a step 90, the charge/discharge current $I_{B2}$ is accumulated by the current accumulating unit 9d based upon the read data so as to obtain the battery capacity at the present driving operation in addition to the initial capacity obtained at the step 60, namely the above-described second battery capacity $VI_2$ is obtained. Then, the resultant battery capacity is stored in the battery capacity monitor unit 9g. In other words, the second battery capacity $VI_2$ which varies moment by moment is continuously detected. Then, at a step 100, based upon information about the charge/discharge current $I_{B2}$ of the battery 1, the voltage $V_{B2}$; the temperature $T_{B2}$, the second battery capacity $VI_2$ and the upper limit capacity $VI_0$, and also the information on the engine $\alpha$, the control for the alternator 5 is performed. Now, this control will be explained in the order of ① normal drive operation, ② idle operation, ③acceleration operation, and ④deceleration operation, based upon the following tables 2 through 4.

(table 2)

| | Control charge current $I_{BC}$ [A] | | | |
|---|---|---|---|---|
| automobile control / Charge condition | full charge | good | no good | dangerous |
| normal drive | 0 | 5 | 30 | |
| idle operation radpid load reduction | 30 | | | |
| acceleration | 0 | | 30 | |
| deceleration | 30 | | | |
| load control | 0 | | 30 | |

(table 3)

| | Control voltage $V_{BC}$ [V] | | | |
|---|---|---|---|---|
| battery temperature / charge condition | full charge | good | no good | dangerous |
| 40 - 90°C | 12.8 | 13.5 | 14.0 | 14.5 |
| 20 - 40°C | 12.8 | 14.0 | 14.5 | 15.0 |
| -30 - 20°C | 12.8 | 14.5 | 15.0 | 15.5 |

(table 4)

| | Control voltage $V_{BC}$ [V] | | | |
|---|---|---|---|---|
| charge condition / automobile mode | full charge | good | no good | dangerous |
| idle operation rapid load reduction | +0.5 | | | present |
| acceleration | -2.0 | | | present |
| deceleration | +2.2 | +1.0 | +0.5 | present |
| load control | 12.8 | | | present |

It should be noted that the table 2 is a table representative of a control charge current $I_{BC}$ supplied to the battery 1 in response to the condition (charge condition) of the battery 1 and the automobile mode; the table 3 is a table indicative of a control voltage $V_{BC}$ applied to the battery 1 at the normal condition, depending upon the conditions of the battery 1 and the battery temperature, and the table 4 is a table representative of variations in setting the control voltage $V_{BC}$ during the normal operation as shown in the table 3, in response to the automobile mode.

①Normal Drive Operation

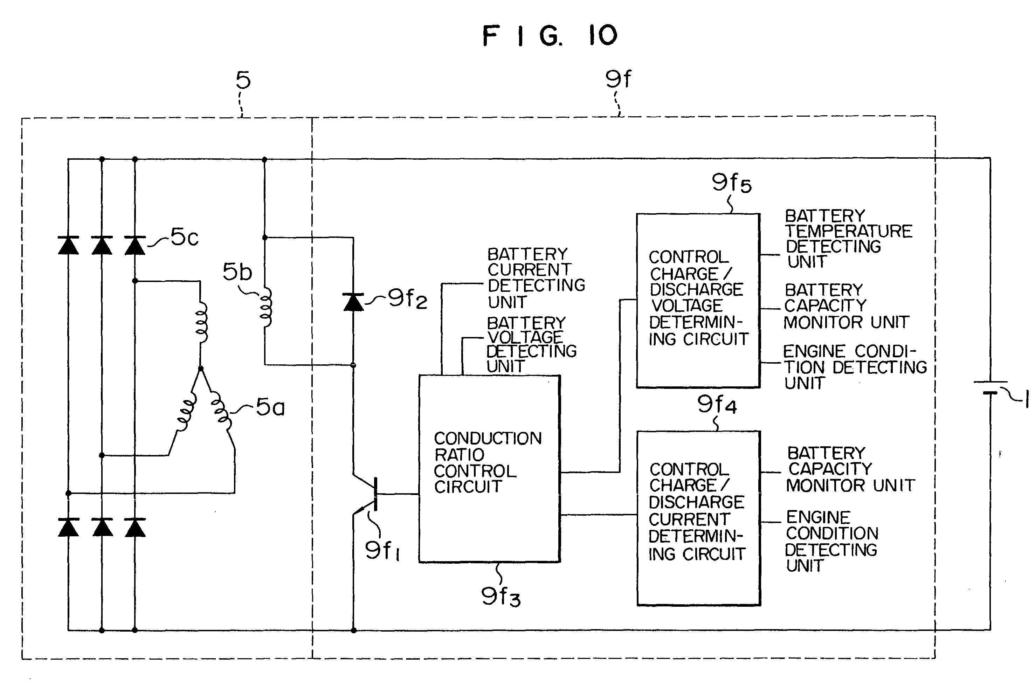

As shown in Fig. 10, the alternator 5 includes an armature winding 5a, a field winding 5b and a full-wave rectifier 5c. An alternator control unit 9f is constructed of a transistor $9f_1$ for controlling a current flowing through the field winding 5b; a flywheel diode $9f_2$ connected across the field winding 5b; a conduction ratio control circuit $9f_3$ for controlling the conduction ratio of the transistor $9f_1$; a control charge/discharge current determining circuit $9f_4$ determining the control charge/discharge current $I_{BC}$; and a control voltage determining circuit $9f_5$ determining the control voltage $V_{BC}$.

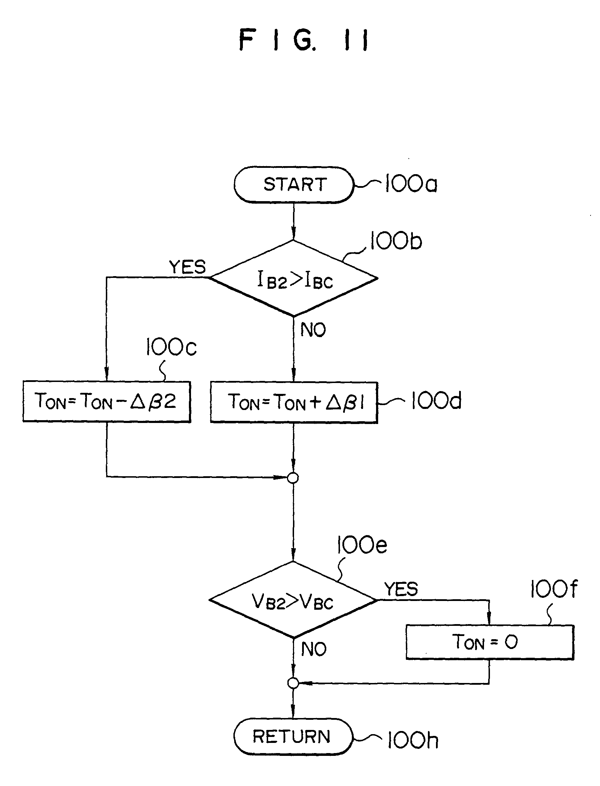

Then, the operations will now be explained in accordance with a flow chart shown in Fig. 11. At a step 100b of this flowchart, the charge current $I_{B2}$ to the battery 1 is detected and this charge current $I_{B2}$ is compared with the control charge current $I_{BC}$ determined by the control charge current determining circuit $9f_4$. Then, in case when the charge current $I_{B2}$ is higher than the control charge current $I_{BC}$, an ON time $T_{ON}$ of the transistor $9f_1$ which has been stored at the present is reduced by $\triangle\beta_2$ at a step 100c. In case when the control charge current $I_{BC}$ is higher than the charge current $I_{B2}$, the ON time $T_{ON}$ of the transistor $9f_1$ which has been stored at the present is increased by $\triangle\beta_1$.

At a step 100e, the voltage $V_{B2}$ of the battery 1 is detected, and then this voltage $V_{B2}$ of the battery 1 is compared with the control voltage $V_{BC}$ determined by the control voltage determining circuit $9f_5$. Then, if the voltage $V_{B2}$ of the battery 1 is higher than the control voltage $V_{BC}$, the ON time $T_{ON}$ of the transistor $9f_1$ is selected to be zero so as to interrupt the operation of the alternator 5 at a step 100f, so that the overcharge to the battery 1 is prevented, or the problem given to the electric load, which is caused when the voltage of the battery 1 becomes too high, is prevented.

On the other hand, when the voltage $V_{B2}$ of the battery 1 is lower than the control voltage $V_{BC}$, the transistor $9f_1$ is brought into the conduction state for only the time $T_{ON}$ which has been determined at the previous step 100c or 100d. Then, a control loop (step 80, 90, 160, 100, 110 and 120) where the control for the drive operation is carried out, is supervised at a calculation period of 10 ms (step 170). Thus, the ON time is increased or decreased for a constant time ($\triangle\beta_1$ or $\triangle\beta_2$) every 10 ms, and the charge current of the battery 1 is adjusted in such a manner that the voltage of the battery 1 approaches the control charge current (a predetermined current) $I_{BC}$ at a predetermined velocity. (It is shown that the previously stated controls are executed by the battery current adjusting means, and is covered by the control of the conduction ratio control circuit $9f_3$).

Assuming now that the above-described initial capacity belongs to the good charge zone shown in Fig. 7, the upper limit capacity $VI_0$ is set to $VI_3$+5 Ah based on the table 1. Then, it is also assumed that this upper limit capacity $VI_0$ belongs to the good charge zone. At this time, since the second battery capacity $VI_0$ is under the good condition, the control charge current $I_{BC}$ is set to 5A, as represented in the table 2, by way of the control charge current determining circuit $9f_4$, and the control voltage $V_{BC}$ is set by way of the control voltage determining circuit $9f_5$, depending upon the temperature $T_{B2}$ of the battery 1. Then, the battery 1 is so controlled as to be continuously charged at the control charge current 5A.

When the battery 1 is charged at the above-described control charge current $I_{BC}$, the second battery capacity $VI_0$ starts to be increased, and then reaches the upper limit capacity $VI_0$, both the control charge current $I_{BC}$ and control voltage $V_{BC}$ are set by the control charge current determining circuit $9f_4$ and control voltage determining circuit $9f_5$ in such a manner that the control charge current $I_{BC} = 0$ A and the control voltage $V_{BC} = 12.8$ V, respectively, in the full charge zone shown in the table 1, and then the charging operation to the battery 1 is stopped and also the increase in the second battery capacity $VI_2$ is stopped.

Since the battery 1 is not charged thereafter, the battery discharges. When the second battery capacity $VI_2$ is decreased by a predetermined value from the upper limit capacity $VI_0$, the control charge current $I_{BC}$ and control voltage $V_{BC}$ are set to the corresponding control charge current and control voltage, depending upon the present conditions of the battery 1. In this example, as previously stated, since it is assumed that the upper limit capacity $VI_0$ belongs to the good charge zone, the control charge current $I_{BC}$ is equal to 5A and the control voltage $V_{BC}$ is equal to 14.0 V. Again, the charge operation of the battery 1 is commenced so that the second battery capacity $VI_2$ is recovered. Subsequently, the above-described condition is repeatedly controlled.

During the control for the normal drive operation, when the electric load 8 is heavy and the second battery capacity $VI_2$ is entered into the good charge zone, as shown in the table 2, the charge current to the battery 2 is set to zero (control charge current $I_{BC} = 0$) and also the current supplied from the alternator 5 is supplied only to the electric load 8, so that power generated from the alternator 5 is lowered and the load control for increasing the fuel efficiency is carried out. At this time, when the battery 1 is gradually discharged and the second battery capacity $VI_2$ is reduced by a predetermined amount, the load control is released and the battery 1 is again charged.

Also, with respect to the above-described control, assuming now that only the upper limit capacity $VI_0$ is entered into the full charge zone, when the second battery capacity $VI_2$ is entered into the full charge zone, the battery 1 is controlled at the control charge current $I_{BC}$ and control voltage $V_{BC}$ defined under the full charge zone. Since this control is such that the battery 1 is not charged, it is possible to prevent the overcharge operation. On the other hand, when the battery capacity is reduced to the good charge zone due to the discharge operation, the present control is changed into the control for the good charge zone. When this control is entered into the full charge zone, this control again changed into the control for the full charge zone.

As a consequence, if the upper limit capacity $VI_0$ is set higher than the capacity (25Ah) of the battery 1 defined when the control is changed into the control for the full charge zone, the battery 1 is not charged up to this upper limit capacity $VI_0$ during the normal drive operation. It should be noted that the control is changed into such a control capable of charging the battery 1 up to this upper limit capacity $VI_0$ during the deceleration control (will be discussed).

Also, the above-described load control is carried out only when the second battery capacity $VI_0$ under use is entered into the full charge zone and good charge zone.

② Idling operation (driving operation under which the engine is revoluted at a speed lower than a predetermined speed).

When the second battery capacity $VI_2$ is present other than the dangerous zone for battery charge, and also the light electric load 8 is changed into the heavy electric load 8 during the idling operation, power generation by the alternator 8 is delayed with respect to this change. As a result, since the charge current into the battery 1 is supplied to the electric load 8 if the battery 1 is being charged by the alternator 5 at this time, the charge current is temporarily reduced. If the battery 1 is not under charge, the current from the battery 1 is supplied to the electric load 8 so that the discharge current is temporarily increased. Such a rapid change in the battery current is detected by the current detector 6 so as to sense that the heavy electric load is loaded.

Conversely, in case that a condition where the electric load 8 is loaded (for instance, DUTY RATIO of the field coil current supplied to the field coil 5b is higher than 80%) is changed into another condition where this electric load 8 is cut out during the idle operation of the engine 2, since the current which has been supplied from the alternator 5 to the cut-out electric load 8 is temporarily supplied to the battery 1, the charge current is suddenly increased. The rapid change in decreasing the heavy electric load 8 is detected by detecting the rapid increase in this charge current by the current detector 6.

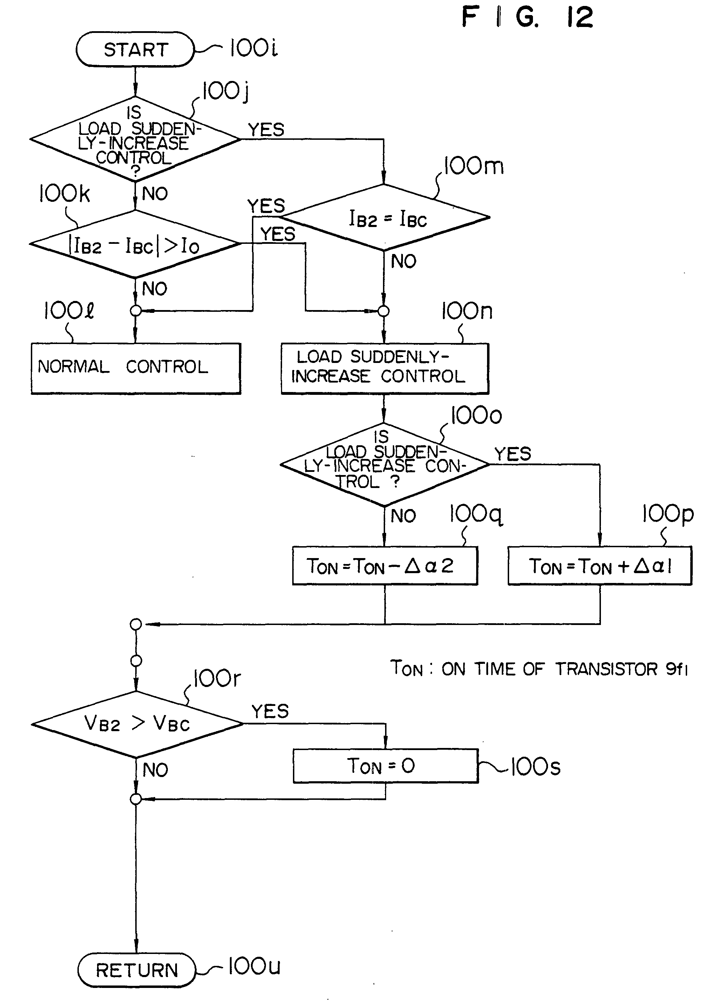

The above-described controls performed when the load is suddenly increased or decreased (will be referred to as a "load suddenly change control") will now be explained with reference to a flow chart shown in Fig. 12.

At a first step 100j, a detection is made whether or not the load suddenly-change control is under operation at present time. Since this is cleared when an IG (ignition) switch (not shown) is turned ON, a detection is made of a difference between either the charge current or discharge current $I_{B2}$ of the battery 1, and the control charge current $I_{BC}$ thereof at the next step 100k.

As previously explained, since it is so controlled that either the charge current or discharge current $I_{B2}$ of the battery 1 approaches the control charge current $I_{BC}$ at a predetermined velocity, and is also controlled at a preselected velocity when the electric load 8 is loaded or interrupted, the alternator 5 cannot immediately respond to the variations in the electric load 8, resulting in a time delay. As a consequence, when the electric load 8 is increased, the current is supplied from the battery 1 to the electric load 8, whereas when the electric load 8 is decreased, the charge current is supplied from the alternator 5 to the battery 1, so that a difference between the current $I_{B2}$ of the battery 1 and the control charge current $I_{BC}$ becomes large.

Therefore, the discharge current is indicated by a symbol different from the symbol representative of the charge current, if an absolute value of the difference between the current of the battery 1 and the control charge current $I_{BC}$ is smaller than a preselected value $I_0$ (for instance, 15A), it is judged that there is no sudden change in the load, whereby the normal control is performed at a step 100ℓ (As previously stated, the detection of the electric load 8 is carried out by the electric load detecting means, and it is shown in this preferred embodiment that this electric load detecting means is contained in the conduction ratio control circuit $9f_3$). This normal control is the same as the control effected under the above-described normal driving condition, the explanation of which is omitted.

Subsequently, a description will now be made of such a case that the electric load 8 is suddenly changed. Once a detection is made that the absolute value of the difference between either the charge current or discharge current $I_{B2}$ of the battery 1 and the control charge current $I_{BC}$ at the step $100_K$ from the normal control state, the load suddenly-change control is commenced at a step 100n. At this time, it is memorized that the control is under the load suddenly-change control. At a step $100_0$, a judgement is made that the electric load 8 is rapidly increased when $I_{B2}-I_{BC} < 0$, based on the difference between the current $I_{B2}$ of the battery 1 and the control charge current $I_{BC}$ which has been calculated at the previous step $100_K$, assuming now that the symbol of the charge current is, for instance, (+). At a step 100p, the ON time $T_{ON}$ of the transistor $9f_1$ is increased by $\triangle\alpha_1$ that is smaller than $\triangle\beta_1$ during the normal driving operation.

Here, a judgement is made that the electric load 8 is suddenly decreased if $I_{B2}-I_{BC} > 0$, and the ON time $T_{ON}$ of the transistor $9f_1$ is decreased by $\triangle\alpha_2$ which is smaller than $\triangle\beta_2$ during the normal driving operation. Furthermore, at this time, as shown in the table 2, the control charge current $I_{BC}$ is set to 30A, the control voltage $V_{BC}$ is increased by 0.5V as shown in the table 4, whereby it is so set that the amount of the charge into the battery 1 is increased.

Thereafter, the voltage $V_{B2}$ of the battery 1 is compared with the control voltage $V_{BC}$ at a step 100r, which is similar to the control performed during the normal driving operation, and only if the voltage $V_{B2}$ of the battery 1 is higher than the control voltage $V_{BC}$, the power generation by the alternator 5 is interrupted. Then, this control is carried out every 10 ms, which is similar to the control effected during the normal driving operation.

Thereafter, since it has been memorized that the control is performed under the load suddenly-change control at the previous calculation operation, the process is advanced to a step 100m at the step 100j, at which the charge current $I_{B2}$ of the battery 1 is compared with the control charge current $I_{BC}$. If both of the currents are equal to each other, it is judged that after the charge current is gradually increased or decreased by the load suddenly-change control, this charge current reaches the control charge current $I_{BC}$, and the control is performed under the normal control at a step 100ℓ, and then at this time, it is memorized that the control is carried out under the normal control. If the charge current $I_{B2}$ of the battery 1 is not equal to the control charge current $I_{BC}$ at a step 100m, the load suddenly-change control is again performed at a step 100m. It should be noted that when the absolute value of the difference between the charge current $I_{B2}$ of the battery 1 and the control charge current $I_{BC}$ is equal to a preselected value, the normal control operation may be performed.

As previously stated, the problems such as engine stall may be prevented because the load on the engine 2 is suddenly increased, by surely detecting such a case that the electric load 8 is loaded during the idling operation, by gradually increasing the field current of the alternator 5 at this time instant so as to gradually increase the power generated by the alternator 5, whereby it may be avoided that the load loaded on the engine 2 is suddenly increased.

Conversely, the problems such as an increase in the engine revolution may be prevented because the load given to the engine 2 is suddenly decreased, by surely detecting such a case that the electric load 8 is interrupted during the idling operation, by gradually decreasing the power generated by the alternator 5 at this time instant, during which the charge current to the battery 1 is increased, whereby it may be avoided that the load given to the engine 2 is suddenly decreased.

It should be understood that when DUTY RATIO of the field current of the alternator 5 which flows through the field coil 5b is higher than 90% and then the electric load 8 is loaded on the engine, the field current means not be

gradually increased.

③Acceleration

When the engine is accelerated during the drive operation, the fuel intake pressure is increased, which is detected. As represented in the above-described tables 2 and 4, in case that the second battery capacity $VI_2$ during the drive operation is entered into either the full charge zone or the good charge zone, the control voltage $V_{BC}$ is set to such a control voltage lower than the control voltage $V_{BC}$ by 2V which has been set before the acceleration, and also the control charge current $I_{BC}$ is set to O(A), so that the power generated by the alternator 5 is decreased and the acceleration characteristic is improved.

On the other hand, if the condition of the battery 1 is under the no good condition or the dangerous condition, the charge operation must be continued, so that even during the acceleration, the control operation by the control voltage $V_{BC}$ and control charge current $I_{BC}$ which have been set before the acceleration is continued.

④Deceleration

When an automobile is decelerated during drive operation, or driven on a down slope, as shown in the tables 2 and 3, the control charge current $I_{BC}$ is set to 30A. In case that the second battery capacity $VI_2$ is entered into the full charge zone, 2.2V is added to the control voltage $V_{BC}$ which has been set before the deceleration condition. In case that the second battery capacity $VI_2$ is entered into the good charge zone, 1.0V is added to the above-described control voltage $V_{BC}$, and in case that this battery capacity is entered into the no good charge zone, 0.5V is added to this control voltage $V_{BC}$. Furthermore, the control voltage $V_{BC}$ is set to 15V and also the upper limit capacity $VI_0$ of the second battery capacity $VI_2$ during the drive operation is changed to a value to which the correction value "C" for instance 5 Ah, is added. Thus, the power generated by the alternator 5 is increased by charging the battery 1, the engine break operation is made great in order to support the deceleration operation, and also the energy produced during the deceleration operation is regenerated thereby to charge the battery 1.

On the other hand, when the second battery capacity $VI_2$ is entered into the dangerous zone for the battery, if the control charge current $I_{BC}$ and control voltage $V_{BC}$ are set to values higher than the values shown in the tables 2 and 3, the adverse influence might be given to the electric load 8, whereby these voltage/ current setting changes are not performed.

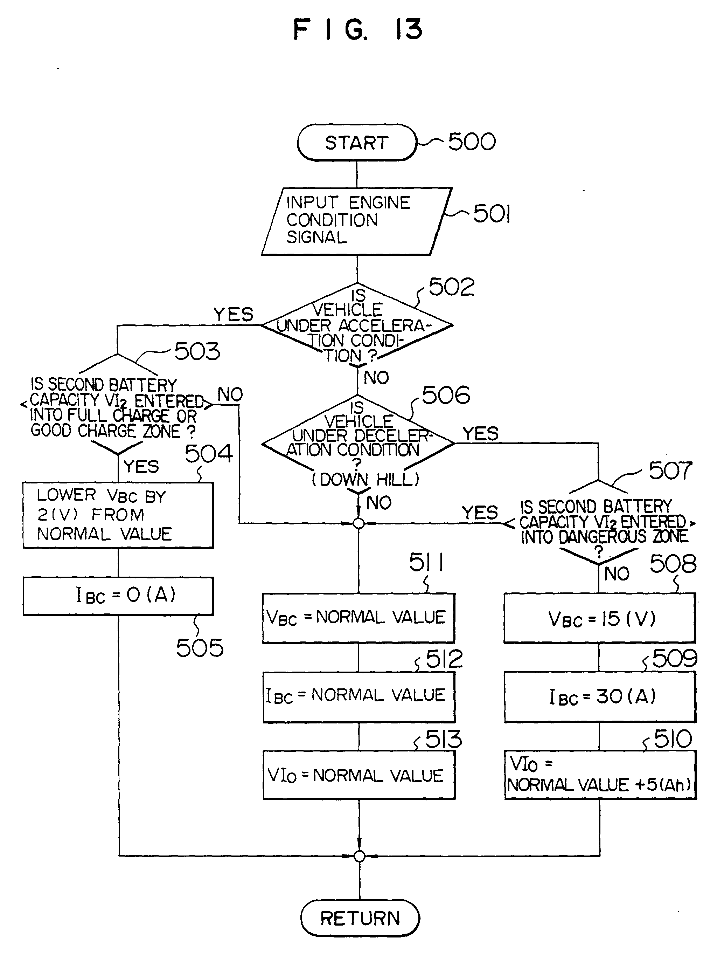

The above-described controls for the acceleration and deceleration operations will now be described with reference to Fig. 13. At a first step 501, an engine condition signal is inputted. The engine condition signal implies a positional sensor of a throttle valve and an air-intake pressure sensor of an intake manifold for an engine, by which signals representative of an acceleration condition, a deceleration condition and a down slope condition of an automobile may be detected. Subsequently, a judgement is made whether or not the vehicle is under the acceleration condition at a step 502. If the judgement result is that the vehicle is under the acceleration condition, a check is made whether the second battery capacity $VI_2$ during the drive operation is entered into the full charge zone or good charge zone at a step 503. Then, if the judgement result is made that the second battery capacity $VI_2$ is entered into either the full charge zone or good charge zone, as represented in the above-described table 4, the control voltage $V_{B2}$ is lowered by 2V at a step 504, and the control charge current $I_{BC}$ is set to O A at a step 505.

On the other hand, when it is judged that the vehicle is not under the acceleration condition at the above step 502, another check is made whether or not the vehicle is under the deceleration condition or down slope driving condition at a step 506. Then, if a judgement is made that the vehicle is under the deceleration condition or down slope driving condition, a check is made whether or not the second battery capacity $VI_2$ is entered into the dangerous zone at a step 507. If a judgement is established that the second battery capacity $VI_2$ is not entered into the dangerous zone, the control voltage $V_{BC}$ is set to 15V at a step 508 and the control charge current $I_{BC}$ is set to 30 A at a step 509. At a next step 510, the upper limit capacity $VI_0$ of the battery capacity $VI_2$ is increased to 5 Ah.

Then, in case that the vehicle's condition is out of the above-described condition, the control charge current $I_{BC}$, control voltage $V_{BC}$ and upper limit capacity $VI_0$ are set to normal values at steps 511 to 513. To avoid overcharge conditions of the battery 1, the above-described period during which the upper limit capacity $VI_0$ is increased under the above-described deceleration operation, may be restricted within a predetermined time period from commencement of the deceleration operation.

Referring back to Fig. 3, in this preferred embodiment, if the second battery capacity $VI_2$ is lower than the setting value of the dangerous zone at a step 110, then warning against dead battery is made by the alarm unit 9i. As previously described, the step 170 sets up the calculation period of 10 ms.

Then, it is judged that the key switch is turned off at a step 120, the final value of the second battery capacity $VI_2$ is stored as a third battery capacity $VI_3$ in the battery capacity monitor unit 9, whereby the subsequent drive operation is prepared.

(Second Preferred Embodiment)

In the above-described first preferred embodiment, when the gassing is detected, the upper limit capacity was set in such a manner that the capacity increased amount "A" which has been set to each zone to which the initial amount of the battery belongs, is added to the initial capacity and the correction value depending on the gassing amount (for instance, gassing amount x 0.8) is subtracted therefrom. To the contrary, in accordance with a second preferred embodiment, a value calculated by subtracting a gassing amount presently detected from the maximum value of the second battery capacity $VI_2$ during the previous drive operation is regarded as an optimum value of the battery capacity, which will be employed as the upper limit capacity which has been explained in the first preferred embodiment

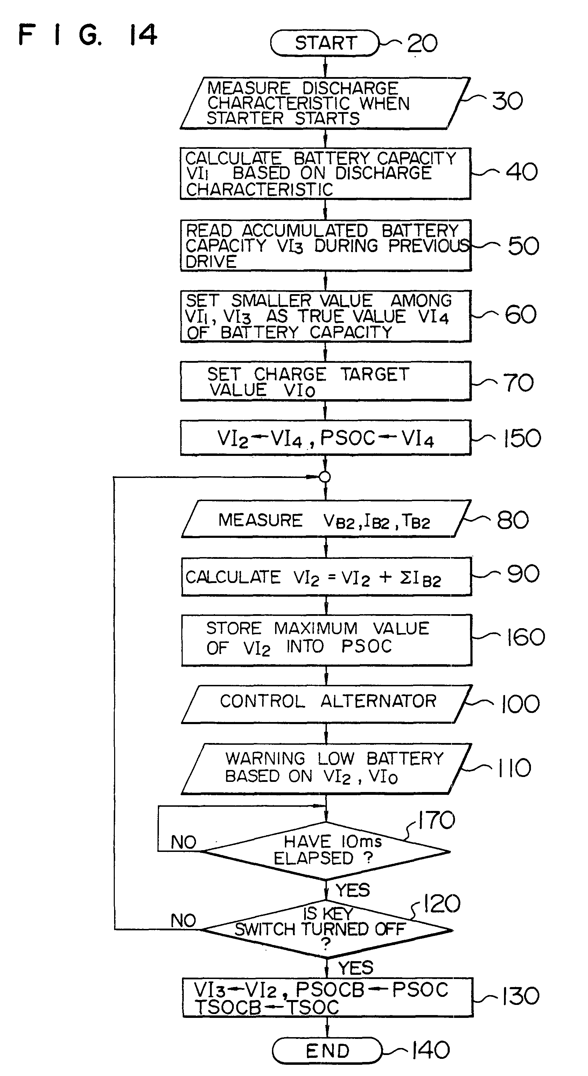

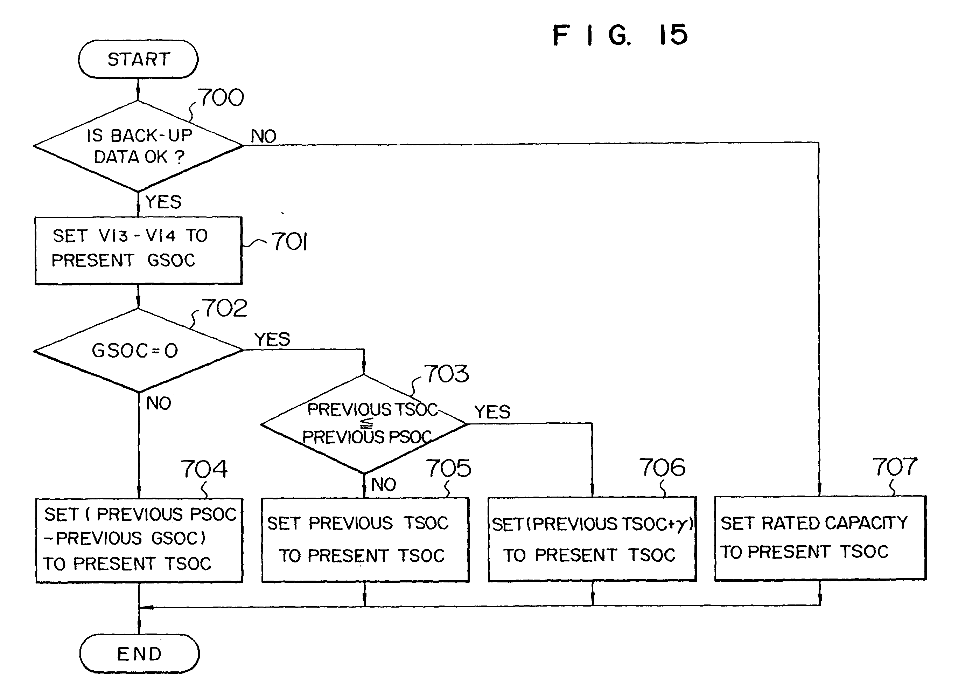

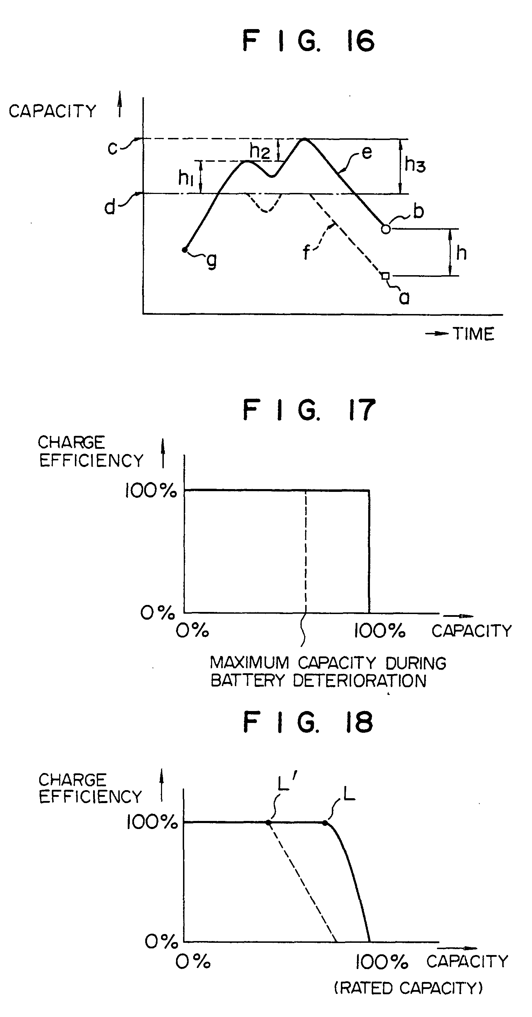

The second preferred embodiment will now be explained with reference to Figs. 14 to 18. Fig. 14 is a flow chart for indicating a control performed in the control circuit 9; Fig. 15 is a flow chart for representing in detail, the process defined at the step 70 of the flow chart shown in Fig. 14; Fig. 16 is a characteristic diagram for showing transition of capacities of the battery 1 from the commencement of the vehicle's drive to the end of the drive operation; Fig. 17 is a characteristic diagram for analogously representing the characteristic of the charge efficiency for the battery 1; and, Fig. 18 is a characteristic diagram for representing the actual charge efficiency of the battery.

In Fig. 14, since the processes defined from the steps 20 to 60 are identical to those shown in Fig. 3 of the first preferred embodiment, the explanation thereof is omitted. A step 70' is such a process to calculate an optimum value TSOC of the battery 1. To explain this calculation more in detail, a check is made at a step 700 shwon in Fig. 15, whether or not both a maximum value PSOCB of the second battery capacity $VI_2$ during the previous drive operation and a optimum value TSOCB which has been calculated during the previous drive operation (which have been stored in the battery capacity monitor unit 9g), are invalidated due to some reasons such as a failure in the power supply back-up. When it is judged that these maximum data PSOCB and TSOCB are invalidated, the present maximum value TSOC is set to a rated capacity at a step 707. This is because the major reasons of the back-up failure are caused by changing the battery 1. However, if the value is set to the actual maximum capacity of the battery 1, there are possibilities to cause the adverse influence such as the overcharge operation, so that this value may be set to approximately 50% of the rated capacity.

At a step 700, if a judgement is made that the back-up data is valid, an amount of gassing GSOS (referred to as an "invalid charge capacity") is calculated at a step 701.

A description will now be made based on the transition of the battery capacity shown in Fig. 16. Symbol "g" shown in Fig. 16 indicates an initial capacity $VI_4$ during the previous drive operation. Then, as previously stated, the later charge/discharge currents is multiplied with this initial capacity $VI_4$(g) so as to obtain the second battery capacity $VI_2$(e) during the drive operation. This is performed by the process defined at the step 90 shown in Fig. 3 of the first preferred embodiment. Symbol "f" indicates the transition of the practical battery capacity in which the charge efficiency has been considered. As shown in Fig. 17, when the actual battery capacity exceeds the optimum value TSOC (d) of the battery 1, since the charge efficiency becomes 0%, the battery 1 is not charged. Since the characteristic of the charge for the battery is approximated, the maximum value is equivalent to the optimum value TSOC. On the other hand, since the second battery capacity $VI_2$(e) is obtained, taking account of the charge efficiency, even when it exceeds the optimum value TSOC (d), the multiplication where the charge efficiency is 100% is continued and this capacity is calculated as being higher than the optimum value TSOC (d). In other words, the capacity higher than the optimum value TSOC (d) corresponds to the invalid charge capacity GSOC. Symbol "b" denotes a third battery capacity $VI_3$, and is a final value of the second battery capacity $VI_2$(e) which has been accumulated by involving the invalid charge capacity GSOC during the previous drive operation. On the other hand, the initial capacity $VI_4$ during the previous drive operation must be coincident with the final value (a) of the transition (f) of the actual battery capacity at the previous drive operation. As a result, it may be understood that the invalid charge capacity GSOC during the previous drive operation is represented by "h" corresponding to the difference between the third battery capacity $VI_3$(b) and the actual battery capacity (= initial capacity $VI_4$ during the previous drive operation) (a). As a result, at a step 701, the difference between the third battery capacity $VI_3$ and the initial capacity $VI_4$ during the previous drive operation is understood as the invalid charge capacity GSOC during the previous drive operation.

At a step 702, a check is made whether or not the invalid charge capacity GSOC is equal to "0". If the invalid charge capacity GSOC is not equal to "0", then the optimum value TSOC is calculated at a step 704. It should be noted that the condition where the invalid charge capacity GSOC becomes zero corresponds to such a case that the charge/ discharge operations during the previous drive operation are performed in a region where the charge efficiency is lowered and no gassing occurs. Here, the invalid charge capacity GSOC during the previous drive operation is a value "$h_3$" obtained by adding "$h_1$" and "$h_2$" with each other as shown in Fig. 16. The invalid charge capacity GSOC corresponds to the difference "h3" between the maximum value PSOC (c) of the second battery capacity $VI_2$ and the optimum value TSOC (d) even when the battery 1 is charged/ discharged under any types of patterns. As previously stated, the invalid charge capacity GSOC during the previous drive operation has been calculated at the step 701, and then the invalid charge capacities GSOC which have been obtained by these two methods are equal to each other. As a result, the optimum value TSOC of the battery 1 is calculated at a step 704 by subtracting the invalid charge capacity GSOC obtained at the step 701 from the maximum value PSOC of the second battery capacity $VI_2$ during the previous drive operation.

On the other hand, when a judgement is made that the invalid charge capacity GSOC is equal to zero at the step 701, the maximum capacity TSOCB which has been calculated during the previous drive operation at the step 703 is compared with the maximum value PSOCB of the second battery capacity $VI_2$ during the previous drive operation. If it is judged that PSOCB $\geqq$ TSOCB, then it implies that although the battery 1 has been charged up to the optimum value TSOC which has been calculated during the previous drive operation, no gassing occurs. In other words, it implies that the battery is charged in the region where the charge efficiency is equal to 100%. As a consequence, it may be judged that the optimum value TSOCB which has been calculated during the previous drive operation was a value lower than the actual optimum value. Therefore, the present optimum value TSOC is corrected as the previous optimum value TSOCB+$\gamma$ at a step 706. This correction value "$\gamma$" may be selected to be a fixed value such as 1 Ah , or be a value calculated under the charge condition.

As previously described in the first preferred embodiment, the calculated optimum value TSCO corresponds to the upper limit capacity $VI_0$. During the vehicle's drive operation, the battery 1 is charged up to this optimum value TSOC as a target. AS previously stated in connection with the first preferred embodiment, also in the second preferred embodiment, when the second battery capacity $VI_2$ during the drive operation reaches the optimum value TSOC (the upper limit capacity $VI_2$ in the second preferred embodiment), such a control that the charge current to the battery 1 is set to zero is basically performed. Therefore, the above described correction of the optimum value TSOC is carried out. However, in such a case that, for instance, even when the second battery capacity $VI_2$ reaches the optimum value TSOC, such a control of capable of still charging the battery 1 may be effected, it may be conceived such a case that the second battery capacity $VI_2$ during the second drive operation exceeds the previously determined optimum value TSOCB and also when the present invalid charge capacity GSOC is calculated, it was zero. In this case, since a judgement may be made that the optimum value TSOCB which has been calculated during the previous drive operation was smaller than the actual optimum value TSOC is substituted by the maximum value PSOCB of the second battery capacity $VI_2$ during the previous drive operation, or the maximum capacity PSOCB+$\gamma$.

On the other hand, if a judgement is made that PSOCB < TSOCB at the step 703, the present optimum value TSOC is set to the previous optimum value TSOCB.

It should be noted that in such a case when the invalid charge capacity GSOC caused by the gassing is detected in this preferred embodiment, the optimum values are independently calculated during the drive operation. However, since there are errors in the measurements in the actual vehicles, it is useful to employ such a method for weighting the previous optimum value TSOCB and averaging the weighted maximum capacities.

In the above-described embodiments, the description was made that the characteristics of the battery charge efficiency were analogous to the characteristic shown in Fig. 17. However, in the actual case, as shown in Fig. 18, the battery charge efficiency has such a characteristic that the charge efficiency is gradually lowered from the approximately maximum capacity of the battery (i.e., about 80% of the maximum capacity). Thus, in accordance with the second embodiment, the optimum value TOSC is a value between a point (L or L') where the efficiency begins to be lowered and the maximum capacity. Whereas, a difference between the battery capacity at the point (L or L') on the efficiency begins to be lowered and the maximum capacity is equal to on the order of 20% of the rated capacity (4 to 6 Ah). As a consequence, taking account of this fact, the maximum capacity may be readily calculated.

In accordance with such a control that the second battery capacity $VI_2$ does not exceed the optimum value TSOC, when the optimum value TSOC is repeatedly calculated in response to repetitions of the vehicle drive operation, the optimum value TSOC is converged into a point where no gassing happens to occur completely (i.e., a point where the charge efficiency is equal to 10%, an L-point or L'-point shown in Fig. 18). That is to say, the optimum value TSOC represents a limit capacity where the battery 1 can be charged at 100% of charge efficiency. As a result, under such a condition that the battery capacity is lower than the optimum value TSOC, there is an advantage that when the battery is charged, there is no gassing, and the second battery capacity which has been calculated by the accumulated value of the charge/discharge currents of the battery 1 does not contain therein the errors caused by the gassing, whereby the capacity of the battery may be correctly calculated. Further, in the case where a control that charges the battery more than the optimum value TSOC is executed; since, it is known that the charge-efficiency begins to be lowered at the region beyond the optimum value TSOC; it is possible to keep the calculation without decrease in accumulation accuracy, by utilizing arrangement that accumulates value of the currents with considering the charge-efficiency beyond the optimum value.

As previously described, when the upper limit capacity $VI_0$ is calculated at the step 70, the initial values of the respective variables are set at a step 150. In this case, the initial capacity $VI_4$ obtained at the step 60 is substituted as the initial values of the second battery capacity $VI_2$ and maximum value PSOC during the drive operation.

Since the steps 80 to 120 indicative of the control during the drive operation are the same as in the first preferred embodiment, no further explanation thereof is omitted. It should be noted in this second preferred embodiment that when the second battery capacity $VI_2$ of the battery 1 exceeds the optimum value TSOC during the drive operation, the battery is not charged in order that both the control charge current $I_{BC}$ and control voltage $V_{BC}$ are set to those as defined in the full charge condition shown in the tables 2 and 3. Then, since the batteries 1 is charged in the range where the charge efficiency is always 100%, there is no possibility that the gassing happens to occur and also no invalid charge capacity is contained in the accumulated value, precision in detecting the battery 1 may be considerably improved. It should be noted that the warning for the low battery performed at the step 110 may be executed when the optimum value TSOC is lowered to a certain value (for example, 30% of the rated capacity).

The function of the step 160 is to store the maximum value of the second battery capacity $VI_2$ during the drive operation as "PSOC" in the battery capacity monitor unit 9g. Thus, the maximum values PSOC of the second battery capacities $VI_2$ that vary from time to time are continuously stored. The step 170 is to set a calculation period of 10 ms.

At the step 120, if a judgement result is made that the key switch is turned off, the final value of the second battery capacity $VI_2$, the maximum value PSOC of the second battery capacity $VI_2$, and the optimum value TSOC are stored as the third battery capacity $VI_3$, PSOCB, and TSOCB, respectively, in the battery capacity monitor unit 9g, and then the system is prepared for the next drive operation.

As previously described, in accordance with the second preferred embodiment of the charge control apparatus of the present invention, since the maximum capacities of the battery can be continuously grasped, the battery is not charged with the capacity higher than the maximum capacity thereof in order to prevent the overcharge operation, and also it can be easily judged both the deterioration and lifetime of the battery. Furthermore, since the optimum value is calculated at the limit capacity where the charge-efficiency is 100%, the battery is not charged but the correct battery capacity may be calculated with employment of the accumulated value of the charge/discharge currents for the battery within the region where the charge efficiency is lowered.

Also as explained above, in accordance with the preferred embodiments of the charge control apparatus of the present invention, since the condition (degree of deterioration) of the battery is detected when the vehicle starts to drive and then the upper limit capacity for charging the battery in response to this detected condition is set, the battery is not overcharged during the drive operation but can be charged under proper charge conditions. Then, since when the vehicle is driven under deceleration condition or along the (down slope, both the control voltage and control charge current are increased to a certain current by which the electric load is not adversely influenced, and also the upper limit capacity is increased depending on the battery conditions detected when the vehicle states to drive, the regeneration effect may be achieved, taking account of the battery conditions.

(Current Detection Apparatus)

A current detection apparatus suitably employed in the present invention will now be described.

As the conventional technique for measuring charge/discharge currents of a battery mounted on a vehicle, a shunt resistor is inserted into a bus line and a bus line current is calculated based upon a voltage drop across this shunt resistor. There is a problem that the bus line must be electrically cut so as to insert the shunt resistor into the bus line.

As a consequence, in a current detection apparatus according to this preferred embodiment, it comprises: a magnetic core having a gap; a first winding passing through the magnetic core and magnetically coupled with a bus line connected to a terminal of a battery and also the magnetic core; a magnetic sensor arranged in the gap, for generating an output in response to a magnetic flux produced within the magnetic core; a second winding magnetically intersected with the magnetic core, through which a predetermined current flows; and also a magnetic balance controller for causing a balance current to flow through the first winding, said balance current having such a magnitude to produce a magnetic flux so as to cancel magnetic fluxes generated by charge/discharge currents of the battery flowing through the bus line and also by said predetermined current, whereby a current flowing through the bus line is obtained based upon the magnitude of this balance current. As a result, the magnitude of the bus line current can be measured without electrically cutting the bus line.

The magnetic fluxes are generated in the magnetic core by the bus line current of the bus line and the predetermined current of the second winding.

The magnetic sensor produces the output, depending on the magnetic flux generated in the closed magnetic path of the magnetic core.

The magnetic balance controller causes the balance current to flow through the first winding, by which such a magnetic flux is produced for capable of canceling the magnetic fluxes produced by the bus line current and the predetermined current based upon the output from the magnetic sensor.

The bus line current may be grasped by converting the magnitude of the balance current into the magnitude of the voltage by the resistor and by measuring this voltage.

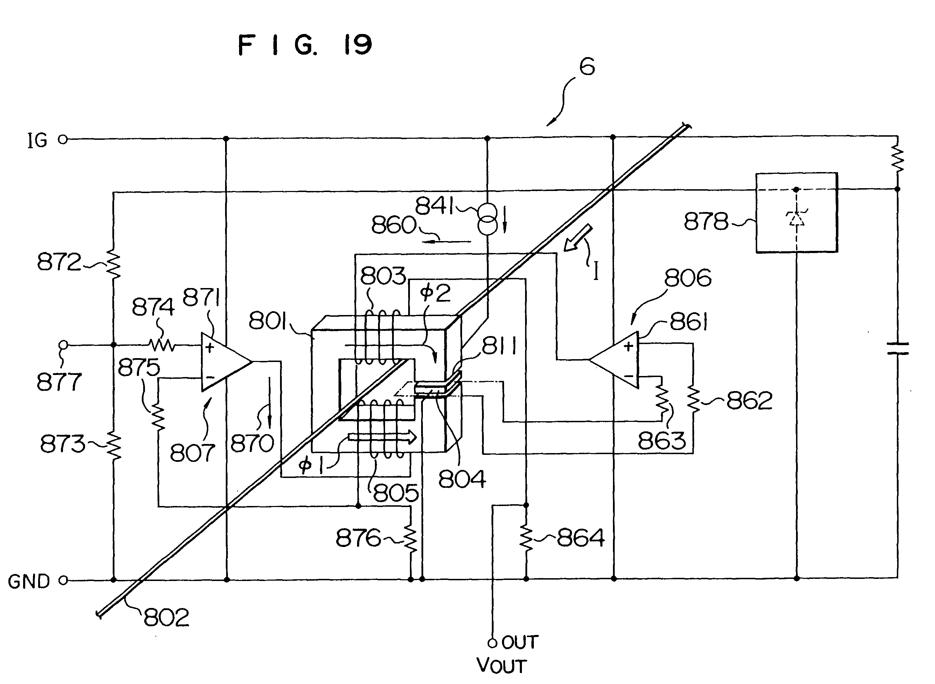

A concrete arrangement of the current detection apparatus according to a preferred embodiment of the present invention will now be described with reference to Figs. 19, 20, 21 and 22.

The current detection apparatus 6 shown in Fig. 19 comprises: an iron core 801, an electric wire 802 functioning as a bus line passing through this iron core 801; a first winding 803 wound on the iron core 801; a Hall element 804; a second winding 805 wound on the iron core 801 and a magnetic balance controller 806.

The iron core 801 is made of a C-type iron core having a gap 811 formed by laminating a thin-plate-like permalloy.

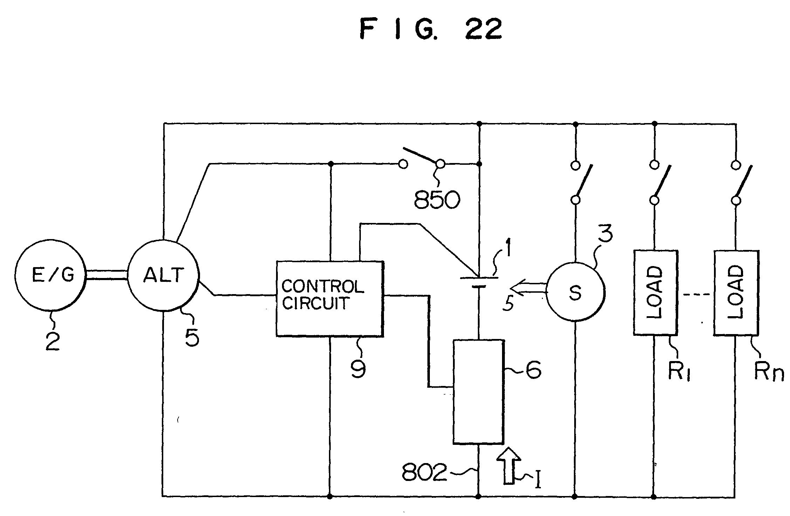

The electric wire 802 is such a wire (see Fig. 22) to electrically connect the battery 1 mounted on the vehicle and the vehicle body, and the number of insertion into the iron core 801 is one. There are possibilities that currents having-100A (maximum charge current) and 300A (maximum discharge current) flow through this electric wire 802.

The first winding 803 is formed in such a manner that, for instance, a conducting wire is wound on the iron core 801 by 1000 turns, and an output resistor 864 having a resistance value of 10 Ω is connected.

The Hall element 804 corresponds to a Hall generator made of such a semiconductor as Ge, InAS and InSb, and generates the output corresponding to the magnetic flux produced in the iron core 801. Reference numeral 841 indicates a constant current source for driving the Hall element 804.

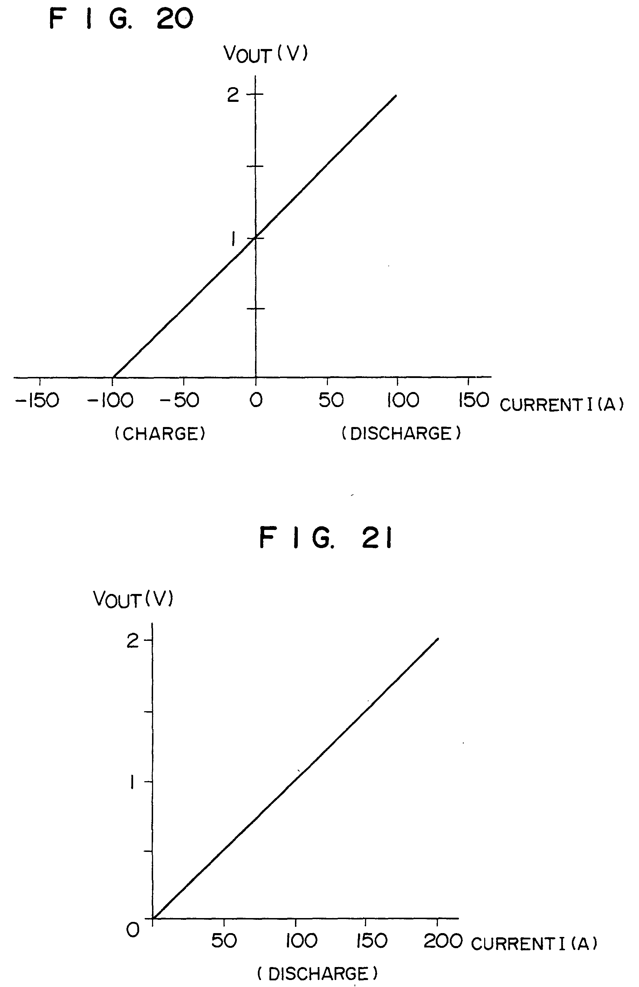

The second winding 805 is formed in such a manner that, for instance, a conducting wire is wound on the iron core 801 in a direction opposite to that of the first winding 803 by 1000 turns, and a resistor 876 having a resistance value of 10 Ω is connected, through which a predetermined current 870 is caused to flow by a bias control circuit 807. This bias control circuit 807 is arranged by an operational amplifier 871 and resistors 872 to 876 in this preferred embodiment, is connected to a terminal GNP, so that the function of the second winding 805 is released, and also is equipped with a control terminal 877 for varying a characteristic as represented in Fig. 20 into a characteristic as shown in Fig. 21. It is so designed that even when the voltage of the battery 1 is changed by a low voltage circuit 878, the predetermined current 870 does not change at all.

The magnetic balance controller 806 is constructed of an operational amplifier 861 and resistors 862 to 864, and has such a function to cause a balance current 860 having a magnitude to the first winding 803, by which a magnetic flux $\phi 2$ is produced so as to cancel a magnetic flux $\phi 1$ generated by the current I and the predetermined current 870 based upon the output of the Hall element 804.

Subsequently, a charge apparatus for an automobile, employing the current detection apparatus 6 will now be explained with reference to Fig. 22. It should be noted that since an arrangement of Fig. 22 is substantially identical to that of Fig. 1, the same circuit elements therein will be indicated by the same reference numerals.

In Fig. 22, symbol E/G indicates an engine; symbol ALT denotes an alternator coupled with the engine E/G by way of a belt; reference numeral 9 represents a control circuit having a calculation circuit; reference numeral 1 indicates a battery; symbol S denotes a starter; symbols $R_1$ to $R_n$ indicate electric loads; and reference numeral 850 is an ignition switch.

Then, operations of the charge apparatus for the vehicle will now be described with reference to Figs. 19 and 22.

(Before Starts of Engine)

The ignition switch 850 is turned on, and thus the voltage of the battery 1 is applied to the terminal IG of the current detection apparatus 6. It should be noted that the control terminal 877 is shortcircuited to the terminal GND by the control circuit, and the function of the second winding 805 is temporarily released.

Assuming now that the electric load $R_1$ is energized and the current I having a value of 10A flows through the electric wire 802.

The magnetic flux $\phi 1$ is generated by the current I having the value of 10A which flows through the electric wire 802, within the closed magnetic circuit of the iron core 801.

The hall element 804 produces the output by this magnetic flux $\phi 1$.

The magnetic balance controller 806 controls the balance current 860 in such a manner that the magnetic flux produced in the closed magnetic circuit becomes zero.

Here, an output voltage $V_{out}$ will be given as follows:

$$V_{out} = \text{(current I/turn number of first winding)} \times$$

$$\text{output resistance of first winding}$$

$$= (10/1000) \times 10$$

$$= 0.1V.$$

(Starter Starts)

Basically, operations when the starter starts are similar to the above-described operations, the current I (pulsatory current) having values of 100A to 300A flows through the electric wire 802 by the operations of the starter S.

Here, an output voltage $V_{OUT}$ (note: pulsatory waveform) will be similarly obtained as follows:

$$V_{OUT} = (100 \sim 300/1000) \times 10$$

$$= 1 \sim 3V.$$

It should be noted that a detected current value of the current I when this starter S starts and the terminal voltage of the battery 1 at this time are supplied to the control circuit, whereby the capacity of the battery 1 before the vehicle is driven is calculated.

(After Engine Starts)

When the engine E/G is driven by starting the starter S, the alternator ALT commences its power generation and then values of the current I flowing through the battery 1 becomes either positive or negative, depending upon the generated current and the load current of the electric load $R_1$/Rn. It should be noted that the control terminal 877 is released by the control circuit in conjunction with starting the engine.

In accordance with this preferred embodiment, since the turn number of the second winding 805 is selected to be 1000 and the resistance 876 is 10 Ω, if the predetermined current 870 is selected to be 100 mA, as shown in Fig. 20, even if this current I is zero, the output voltage $V_{OUT}$ becomes 1V, so that the measurement may be performed up to the output voltage $V_{OUT} = 0V(I = -100A)$.

It should be noted that variations in the current values of the current I are supplied to the control circuit 9 in order to calculate variations in the electric capacity of the battery 1.

Then, the particular advantages of the current detection apparatus 6 and the charge apparatus for the automobile, employing the current detection apparatus 6 will now be explained.

    (a) Since even when the current of the bus line becomes zero, a predetermined current is supplied to the second winding so as to produce the magnetic flux in the closed magnetic core, the value of the current I across a zero current point may be readily obtained from the output voltage $V_{OUT}$ without electrically cutting the bus line.

    (b) Since the polarity of the output from the magnetic sensor and the polarity of the balance current are not changed within the measurement range, the current detection apparatus may be driven by a single power source, and therefore is suitable for automobiles.

    (c) The current detection apparatus is equipped with the control terminal 877. This control terminal 877 is connected to the terminal GND so that the function of the second winding 805 is released. Thus, the measuring range may be changed.

    (d) Since the electric capacity of the battery 1 is continuously grasped by the control circuit 9, both the over discharge and overcharge for the battery 1 may be prevented.

In the current detection apparatus according to the present invention, the magnetic sensor may employ a magnetic resistance element and the like other than the Hall element. Then, to reduce the adverse influences caused by the external magnetic fields such as earth magnetism, gaps may be uniformly formed in the magnetic core, into which the magnetic sensor is inserted, whereby the magnetic balance may be controlled based upon a synthesized output of these magnetic sensors. It should be understood that turn numbers of the first and second windings may be determined to proper values, depnding on the magnitude of the bus line current.

While particular embodiments of the present invention have been shown and described, it will be obvious to those skilled in the art that various changes and modifications may be made without departing from the present invention in its broader aspect.

**Claims**

**1.** A battery condition detecting apparatus comprising:

    battery current detecting means (9a) for detecting charge/discharge currents of a battery (1),

17

battery voltage detecting means (9c) for detecting a voltage on the terminals of the battery (1),
battery current accumulating means (9d) for providing a battery current accumulated value of the charge/discharge currents of said battery which have been detected by said battery current detecting means (9a), and
first battery capacity detecting means (9e) for detecting a first battery capacity on the basis of said voltage which is detected by said battery voltage detecting means (9c) under predetermined operating conditions,

**characterized in that**

said first battery capacity detecting means (9e) detects said first battery capacity on the basis of said voltage which is detected by said battery voltage detecting means (9c) under said predetermined operating conditions represented by the time of application of an electric load which withdraws a discharge current having a magnitude larger than a predetermined value,
an initial capacity determining means (9g) is provided for determining an initial capacity of the battery (1) based upon the first battery capacity detected by said first battery capacity detecting means (9e),
a second battery capacity detecting means (9g) is provided for adding said battery current accumulated value which is determined after the detection of the first battery capacity and which has been accumulated by said battery current accumulating means (9d) to said initial capacity determined by said initial capacity determining means (9g) and thereby determining the resultant value of the addition as a second battery capacity, and
said initial capacity determining means (9g) compares the first battery capacity detected at present time with the second battery capacity determined before the detection of this first battery capacity, this second battery capacity being determined when the engine was stopped at the previous time due to the interruption of the engine operation, and the smaller battery capacity thereof being determined as the initial capacity of the battery (1).

2. A battery condition detecting apparatus according to claim 1,
**characterized in that**

a starter (3) driven by a battery (1) mounted on a vehicle, for starting an engine (2) and an alternator (5) for the vehicle, driven by said engine (2) for charging said battery (1) are provided, and
said first battery capacity detecting means (9e) detects said first battery capacity on the basis of said voltage when the engine is started, whereby said battery voltage is detected by said battery voltage detecting means (9c), after a waiting process, at the time of application of said electric load which withdraws a discharge current having a magnitude larger than a predetermined value during the operation of said starter.

3. A battery condition detecting apparatus as claimed in claim 2,
**characterized in that**
said initial capacity determining means (9g) compares the first battery capacity which is detected when the engine is started at present time, with said second battery capacity when the engine was stopped at the previous time due to the interruption of the engine operation.

4. A battery condition detecting apparatus according to claim 3, **characterized by**
further comprising target value setting means for setting a charge target value of the battery (1) after the engine (2) has started and in correspondence with the initial capacity determined by the initial capacity determining means (9g) of said battery condition detection apparatus, and generation control means for controlling power generated by the alternator (5) for the vehicle in such a manner that said battery is charged at the target value set by said target value setting means.

5. A battery condition detecting apparatus according to claim 4,
**characterized in that**
said target value setting means adds to said initial capacity an increase value (A) so as to obtain the target value, said increase value being set depending on said initial capacity.

6. A battery condition detecting apparatus according to claim 5,
**characterized in that**
the condition of the battery (1) is subdivided into a plurality of conditions of its charge capacity, and said initial capacity setting means (9g) sets the increase value at a value predetermined corresponding to a respective one of said plurality of conditions.

**7.** A battery condition detecting apparatus as claimed in claim 5,
**characterized in that**
when a judgement is made that the second battery capacity is higher than the first battery capacity by comparing said first battery capacity with said second battery capacity, said target value setting means subtracts a correction value from said increase value and adds the resultant value to said initial capacity so as to obtain the target value.

**8.** A battery condition detecting apparatus as claimed in claim 7,
**characterized in that**
said correction value is set directly proportional to a difference between said first battery capacity and said second battery capacity.

**9.** A battery condition detecting apparatus according to claim 4,
**characterized in that**

said target value setting means detects as an invalid charge capacity a value of a difference between the first and second battery capacities when the second battery capacity is higher than the first battery capacity when comparing said first and second battery capacities, and sets in response to the detected invalid charge capacity of the difference value a charge target value of the battery (1) after start of the engine operation, and alternator controlling means are provided for controlling power generated by said alternator for the vehicle in such a manner that said battery is charged at the target value by said target value setting means.

**10.** A battery condition detecting apparatus as claimed in claim 9,
**characterized in that**
said target value setting means subtracts said invalid charge capacity from a maximum value of the second battery capacity just before said first battery capacity is detected for obtaining the target value.

**11.** A battery condition detecting apparatus according to claim 9,
**characterized in that**
said target value setting means sets as a target value at a present time a target value set at a previous time, when detecting zero as the invalid charge capacity of the difference value.

**12.** A battery condition detecting apparatus as claimed in claim 9,
**characterized in that**
said target value setting means sets a present time target value by adding a predetermined value to a previous time target value in response to the detection of the invalid charge capacity of the difference value equal to zero and in response to the detection of a maximum value of the second battery capacity which maximum value was detected by a time just before the detection of said first battery capacity and which maximum value is greater than the previous time target value.

**13.** A battery condition detecting apparatus according to claim 4,
**characterized in that**
when said second battery capacity is greater than said first battery capacity, a difference between said first and second battery capacities is detected as an invalid charge capacity.

**14.** A battery condition detecting apparatus according to claim 4 or 9,
**characterized in that**
said target value setting means changes said target value to a higher target value while the vehicle is driven under a deceleration condition, or a down slope condition.

**15.** A battery condition detecting apparatus according to any of the preceding claims 1, 2 and 3,
**characterized in that**
said battery current detecting means (9a) comprises:

a magnetic core (801) having a gap (811);
a first winding (803) wound on the magnetic core (801) and a bus line (802) connected to a terminal of the battery (1) and magnetically coupled to the magnetic core (801);
a magnetic sensor (804) arranged in the gap, for generating an output in response to the magnetic flux produced within the magnetic core (801);

a second winding (805) magnetically coupled to the magnetic core (801), through which a predetermined biasing current flows; and

a magnetic balance controller (806) for causing a balance current to flow through the first winding (803), said balance current having such a magnitude to produce a magnetic flux so as to cancel magnetic fluxes generated by charge/discharge currents of the battery (1) flowing through the bus line (802) and also by said predetermined biasing current, whereby the value of a current flowing through the bus line (802) is obtained based upon the magnitude of this balance current.

**16.** A method of detecting a battery condition, comprising:

a battery current detecting step for detecting charge/discharge currents of a battery (1),

a battery voltage detecting step for detecting a voltage on the terminals of the battery (1),

a battery current accumulating step for providing a battery current accumulated value of the charge/discharge currents of said battery which have been detected by said battery current detecting step, and

a first battery capacity detecting step for detecting a first battery capacity on the basis of said voltage detected by said battery voltage detecting step under predetermined operating conditions,

**characterized in that**

said first battery capacity detecting step detects said first battery capacity on the basis of said voltage which is detected by said battery voltage detecting step under said predetermined operating conditions represented by the time of application of an electric load which withdraws a discharge current of said battery (1) detected by said battery current detecting step and having a magnitude larger than a predetermined value,

an initial capacity determining step is provided for determining an initial capacity of the battery (1) based upon the first battery capacity detected by said first battery capacity detecting step,

a second battery capacity detecting step is provided for adding said battery current accumulated value which is determined after the detection of the first battery capacity and which has been accumulated by said battery current accumulating step to said initial capacity determined by said initial capacity determining step, the resultant value of the addition being determined as a second battery capacity, and

said initial capacity determining step compares the first battery capacity detected at present time with the second battery capacity determined before the detection of this first battery capacity, this second battery capacity being determined when the engine was stopped at the previous time due to the interruption of the engine operation, and the smaller battery capacity thereof is determined as the initial capacity of the battery (1).

**17.** A method according to claim 16,
**characterized by**
comprising the step of detecting a temperature of the battery by a battery temperature detecting means (7) and correcting the detected battery voltage based on the temperature detected by the battery temperature detecting means (7).

**18.** A method according to claim 16,
**characterized by**
comprising the step of detecting a time period after the start of discharge of the battery until said voltage is detected by the battery voltage detecting means (9c) and correcting the detected battery voltage upon lapse of said time period.

**Patentansprüche**

**1.** Vorrichtung zur Erfassung eines Batteriezustandes, mit:

einem Batteriestrom-Feststellmittel (9a) zum Feststellen von Lade/Entladeströmen einer Batterie (1),

einem Batteriespannungs-Feststellmittel (9c) zum Feststellen einer Spannung an den Polklemmen der Batterie (1),

Batteriestrom-Akkumuliermittel (9d) zum Bereitstellen eines akkumulierten Batteriestromwertes der durch das Batteriestrom-Feststellmittel (9a) festgestellten Lade/Entladeströme der Batterie, und

einem ersten Batteriekapazitäts-Feststellmittel (9e) zum Feststellen einer ersten Batteriekapazität auf der Grundlage der vom Batteriespannungs-Feststellmittel (9c) unter vorbestimmten Betriebsbedingungen festgestellten Spannung,

**dadurch gekennzeichnet, daß**

das erste Batteriekapazitäts-Feststellmittel (9e) die erste Batteriekapazität auf der Grundlage der Spannung feststellt, die das Batteriespannungs-Feststellmittel (9c) unter den vorbestimmten Betriebsbedingungen feststellt, dargestellt durch die Zeit des Anliegens einer elektrischen Last, die einen Entladestrom mit einer Stärke abzieht, die größer als ein vorbestimmter Wert ist,

ein Anfangskapazitäts-Bestimmungsmittel (9g) vorgesehen ist zum Bestimmen einer Anfangskapazität der Batterie (1) auf der Grundlage der ersten Batteriekapazität, festgestellt vom ersten Batteriekapazitäts-Bestimmungsmittel (9e),

ein zweites Batteriekapazitäts-Feststellmittel (9g) vorgesehen ist zum Hinzufügen des nach der Feststellung der ersten Batteriekapazität bestimmten vom Batteriestrom-Akkumuliermittel (9d) akkumulierten Batteriestromwertes zur Anfangskapazität vom Anfangskapazitätsbestimmungsmittel (9g) bestimmten akkumulierten Batteriestromwert, um so den sich ergebenden Wert der Addition als eine zweite Batteriekapazität zu bestimmen, und daß

das Anfangskapazitäts-Bestimmungsmittel (9g) die zur gegenwärtigen Zeit festgestellte erste Batteriekapazität mit der vor Feststellung der ersten Batteriekapazität festgestellten zweiten Batteriekapazität vergleicht, wobei die Bestimmung dieser zweiten Batteriekapazität erfolgt, wenn der Motor vorher aufgrund der Abschaltung des Motors steht und die Bestimmung der geringeren Batteriekapazität als die Anfangskapazität der Batterie (1) erfolgt.

2. Vorrichtung zur Erfassung eines Batteriezustandes nach Anspruch 1,
   **dadurch gekennzeichnet, daß**

   ein von einer Batterie (1) angesteuerter Anlasser (3), der in einem Fahrzeug eingebaut ist, um einen Motor (2) anzulassen, und daß eine vom Motor (2) zum Laden der Batterie (1) angetriebene Lichtmaschine (5) für das Fahrzeug vorgesehen ist, und daß

   das erste Batteriekapazitäts-Bestimmungsmittel (9e) die erste Batteriekapazität auf der Grundlage der Spannung beim Anlassen des Motors feststellt, wodurch das Feststellen der Batteriespannung durch das Batteriespannungs-Feststellmittel (9c) nach einem Warteprozeß zur Zeit des Anlegens der elektrischen Last erfolgt, die einen Entladestrom mit einer Stärke abzieht, die während der Operation des Anlassens größer als ein vorbestimmter Wert ist.

3. Vorrichtung zur Erfassung eines Batteriezustandes nach Anspruch 2,
   **dadurch gekennzeichnet, daß**
   das Anfangskapazitäts-Bestimmungsmittel (9g) die erste zum gegenwärtigen Zeitpunkt beim Anlassen des Motors festgestellte Batteriekapazität mit der zweiten Batteriekapazität vergleicht, wenn der Motor vorher aufgrund der Abschaltung des Motors steht.

4. Vorrichtung zur Erfassung eines Batteriezustandes nach Anspruch 3, **gekennzeichnet durch**
   ein Zielwert-Einstellmittel zum Einstellen eines Ladungszielwertes der Batterie (1), nachdem der Motor angelassen ist und gemäß der Anfangskapazität, bestimmt **durch** das Anfangskapazitäts-Bestimmungsmittel (9g) des Batteriezustands-Feststellgerätes, und **durch** ein Erzeugungssteuermittel zum Steuern der von der Lichtmaschine (5) erzeugten Leistung für den Motor in der Weise, daß eine Batterie zum vom Zielwerteinstellmittel eingestellten Zielwert geladen wird.

5. Vorrichtung zur Erfassung eines Batteriezustandes nach Anspruch 4,
   **dadurch gekennzeichnet, daß**
   das Zielwerteinstellmittel der Anfangskapazität einen Zuschlagswert (A) hinzufügt, um so den Zielwert zu erhalten, wobei das Einstellen des erhöhten Wertes abhängig von der Anfangskapazität erfolgt.

6. Vorrichtung zur Erfassung eines Batteriezustandes nach Anspruch 5,
   **dadurch gekennzeichnet, daß**
   der Zustand der Batterie (1) unterteilt ist in eine Vielzahl von Zuständen der Ladungskapazität, und wobei das Anfangskapazitäts-Einstellmittel (9g) den Zuschlagswert auf einen Wert gemäß einem jeweiligen der Vielzahl von Zuständen vorbestimmten Wert einstellt.

**7.** Vorrichtung zur Erfassung eines Batteriezustandes nach Anspruch 5,
**dadurch gekennzeichnet, daß**

beim Beurteilen durch Vergleichen der ersten Batteriekapazität mit der zweiten Batteriekapazität, daß die zweite Batteriekapazität höher als die erste Batteriekapazität ist, das Zielwerteinstellmittel einen Korrekturwert vom Zuschlagswert subtrahiert und einen resultierenden Wert der Anfangskapazität hinzufügt, um so den Zielwert zu erhalten.

**8.** Vorrichtung zur Erfassung eines Batteriezustandes nach Anspruch 7,
**dadurch gekennzeichnet, daß**

das Einstellen des Korrekturwertes direkt proportional zu einer Differenz zwischen der ersten Batteriekapazität und der zweiten Batteriekapazität erfolgt.

**9.** Vorrichtung zur Erfassung eines Batteriezustandes nach Anspruch 4,
**dadurch gekennzeichnet, daß**

das Zielwert-Einstellmittel eine ungültige Ladungskapazität eines Wertes einer Differenz zwischen der ersten und zweiten Batteriekapazität feststellt, wenn die zweite Batteriekapazität höher als die erste Batteriekapazität ist, wenn die erste mit der zweiten Batteriekapazität verglichen wird, und als Reaktion auf die festgestellte ungültige Ladungskapazität des Differenzwertes ein Ladungszielwert der Batterie (1) nach Anlassen des Motors eingestellt wird, und daß

ein Lichtmaschinensteuermittel vorgesehen ist zum Steuern der Lichtmaschinenleistung für ein Fahrzeug in der Weise, daß die Batterie vom Zielwert-Einstellmittel auf den Zielwert geladen wird.

**10.** Vorrichtung zur Erfassung eines Batteriezustandes nach Anspruch 9,
**dadurch gekennzeichnet, daß**

das Zielwerteinstellmittel die ungültige Ladungskapazität vom Maximalwert der zweiten Batteriekapazität direkt vor Feststellen der ersten Batteriekapazität zum Erlangen des Zielwertes subtrahiert.

**11.** Vorrichtung zur Erfassung eines Batteriezustandes nach Anspruch 9,
**dadurch gekennzeichnet, daß**

das Zielwerteinstellmittel als gegenwärtigen Zielwert einen vorherigen Zielwert einstellt, wenn als ungültige Ladungskapazität des Differenzwertes Null festgestellt ist.

**12.** Vorrichtung zur Erfassung eines Batteriezustandes nach Anspruch 9,
**dadurch gekennzeichnet, daß**

das Zielwerteinstellmittel einen gegenwärtigen Zielwert einstellt durch Hinzufügen eines vorbestimmten Wertes zu einem vorherigen Zielwert als Reaktion auf die Feststellung einer ungültigen Ladungskapazität des Differenzwertes gleich Null und als Reaktion auf die Feststellung eines Maximalwertes der zweiten Batteriekapazität, welcher Maximalwert direkt vor der Feststellung der ersten Batteriekapazität festgestellt wurde, und welcher Maximalwert größer als der frühere Zielwert ist.

**13.** Vorrichtung zur Erfassung eines Batteriezustandes nach Anspruch 4,
**dadurch gekennzeichnet, daß**

eine Differenz zwischen der ersten und der zweiten Batteriekapazität als ungültige Ladungskapazität festgestellt wird, wenn die zweite Batteriekapazität größer als die erste Batteriekapazität ist.

**14.** Vorrichtung zur Erfassung eines Batteriezustandes nach Anspruch 4 oder 9,
**dadurch gekennzeichnet, daß**

das Zielwert-Einstellmittel den Zielwert auf einen höheren Zielwert ändert, während das Fahrzeug langsamer oder bergab fährt.

**15.** Vorrichtung zur Erfassung eines Batteriezustandes nach einem der Ansprüche 1, 2 und 3,
**dadurch gekennzeichnet, daß**

das Batteriestrom-Feststellmittel (9a) ausgestattet ist mit:

einem Magnetkern (801) mit einem Luftspalt (811);
einer ersten Wicklung (803), die um den Magnetkern (801) gewickelt ist, und einer Busleitung (802), die mit einer Polklemme der Batterie (1) verbunden und magnetisch mit dem Magnetkern (801) gekoppelt ist;

einem im Luftspalt angeordneten Magnetsensor (804) zum Erzeugen eines Ausgangssignals als Reaktion auf einen im Magnetkern (801) erzeugten Magnetfluß;

einer zweiten Wicklung (805), die mit dem Magnetkern (801) magnetisch gekoppelt ist, wodurch ein vorbestimmter Vorstrom fließt; und daß

eine magnetische Ausgleichssteuerung (806) vorgesehen ist, um einen Ausgleichsstrom durch die erste Wicklung (803) fließen zu lassen, wobei der Ausgleichsstrom eine solche Stärke hat, daß er einen magnetischen Fluß erzeugt, der die magnetischen Flüsse beseitigt, die durch in der Busleitung (802) fließende Lade/Entladeströme der Batterie (1) und auch durch den vorbestimmten Vorstrom aufkommen, wodurch der Wert eines durch die Busleitung (802) fließenden Stromes auf der Grundlage der Stärke des Ausgleichsstromes erzielt wird.

**16.** Verfahren zur Erfassung eines Batteriezustandes, mit den Verfahrensschritten:

Feststellen von Lade/Entladeströmen einer Batterie (1)
Feststellen einer Spannung an den Polklemmen der Batterie (1),
Akkumulieren eines Batteriestromes zum Bereitstellen eines akkumulierten Batteriestromwertes der im Verfahrensschritt der Feststellung des Batteriestromes festgestellten Lade/Entladeströme der Batterie, und
Feststellen einer ersten Batteriekapazität auf der Grundlage der im Verfahrensschritt des Feststellens der Batteriespannung festgestellten Batteriespannung unter den vorbestimmten Betriebsbedingungen,

**dadurch gekennzeichnet, daß**

der Verfahrensschritt des Feststellens der ersten Batteriekapazität die erste Batteriekapazität auf der Grundlage der Spannung feststellt, die im Verfahrensschritt des Feststellens der Batteriespannung unter den vorbestimmten Betriebsbedingungen festgestellt wird, dargestellt durch die Zeit des Anlegens einer elektrischen Last, die einen Entladestrom der Batterie (1) abzieht, festgestellt im Verfahrensschritt des Feststellens vom Batteriestrom, und mit einer Stärke, die größer als ein vorbestimmter Wert ist,
Bestimmen einer Anfangskapazität der Batterie (1) auf der Grundlage der vom Verfahrensschritt des Feststellens der ersten Batteriekapazität festgestellten ersten Batteriekapazität,
Feststellen einer zweiten Batteriekapazität zum Hinzufügen des akkumulierten Batteriestromwertes, der bestimmt ist nach der Feststellung der ersten Batteriekapazität und der akkumuliert ist im Verfahrensschritt des Akkumulierens vom Batteriestrom, zur anfänglichen Kapazität, die im Verfahrensschritt des Bestimmens der Anfangskapazität bestimmt worden ist, wobei der sich ergebende Wert der Addition eine zweite Batteriekapazität bestimmt, und daß
der Verfahrensschritt des Bestimmens der Anfangskapazität die erste gegenwärtige Batteriekapazität mit der vor der Feststellung dieser ersten Batteriekapazität bestimmten zweiten Batteriekapazität vergleicht, wobei diese zweite Batteriekapazität bei stehendem Motor aufgrund vorheriger Abschaltung des Motors bestimmt wird und die kleinere Batteriekapazität die Anfangskapazität der Batterie (1) bestimmt.

**17.** Verfahren nach Anspruch 16,
**gekennzeichnet durch** den Verfahrensschritt
Feststellen einer Temperatur der Batterie **durch** ein Batterietemperatur-Feststellmittel (7) und Korrigieren der festgestellten Batteriespannung auf der Grundlage der vom Batterietemperatur-Feststellmittel (7) festgestellten Temperatur.

**18.** Verfahren nach Anspruch 16,
**gekennzeichnet durch** den Verfahrensschritt
Feststellen einer Zeitdauer nach dem Beginn der Entladung der Batterie bis zur festgestellten Spannung **durch** das Batteriespanungs-Feststellmittel (9c) und Korrigieren der festgestellten Batteriespannung nach Verstreichen der Zeitdauer.

**Revendications**

**1.** Dispositif de détection de l'état d'une batterie, comprenant :

des moyens (9a) de détection du courant de la batterie pour détecter des courants de charge/décharge d'une batterie (1),

des moyens (9c) de détection de la tension de la batterie pour détecter une tension aux bornes de la batterie (1),

des moyens (9a) d'accumulation du courant de batterie pour délivrer une valeur cumulée des courants de charge/décharge de ladite batterie, qui ont été détectés par lesdits moyens (9a) de détection du courant de la batterie, et

des premiers moyens (9e) de détection de la capacité de la batterie pour détecter une première capacité de la batterie sur la base de ladite tension qui est détectée par lesdits moyens (9c) de détection de la tension de la batterie, dans des conditions de fonctionnement prédéterminées, **caractérisé en ce que**

lesdits premiers moyens (9e) de détermination de la tension de la batterie détectent la première capacité de la batterie sur la base de ladite tension qui est détectée par lesdits moyens (9c) de détection de la tension de la batterie dans lesdites conditions prédéterminées de fonctionnement représentées par la durée d'application d'une charge électrique, qui prélève un courant possédant une amplitude supérieure à une valeur prédéterminée,

des moyens (9g) de détermination de la capacité initiale sont prévus pour détecter une capacité initiale de la batterie (1) sur la base de la première capacité de la batterie détectée par lesdits premiers moyens (9a) de détection de capacité de la batterie,

des seconds moyens (9g) de détection de la capacité de la batterie sont prévus pour ajouter ladite valeur cumulée du courant de la batterie, qui est déterminée après la détection de la première capacité de la batterie et qui a été accumulée par lesdits moyens (9d) d'accumulation du courant de batterie jusqu'à ladite capacité initiale prédéterminée par lesdits moyens (9g) de détermination de la capacité initiale, ce qui permet de déterminer la valeur résultante de l'addition en tant que seconde capacité de la batterie, et

lesdits moyens (9g) de détermination de la capacité initiale comparent la première capacité de la batterie détectée à l'instant présent à la seconde capacité de la batterie déterminée avant la détection de cette première capacité de la batterie, cette seconde capacité de la batterie étant déterminée lorsque le moteur s'est arrêté à l'instant précédent en raison d'une interruption du fonctionnement du moteur, et la capacité plus petite de la batterie associée au moteur étant déterminée en tant que capacité initiale de la batterie (1).

2. Dispositif de détection de l'état d'une batterie selon la revendication 1, **caractérisé en ce que**

   un démarreur (3) activé par une batterie (1) montée sur un véhicule, pour faire démarrer un moteur (2) et un alternateur (5) pour le véhicule, entraîné par ledit moteur (2) pour charger ladite batterie (1), sont prévus, et lesdits premiers moyens (9e) de détection de la capacité de la batterie détectent ladite première capacité de la batterie sur la base de ladite tension lorsque ledit moteur démarre, ce qui a pour effet que ladite tension de la batterie est détectée par lesdits moyens (9c) de détection de la tension de la batterie, après un processus d'attente, au moment de l'application de ladite charge électrique qui prélève un courant de charge possédant une amplitude supérieure à une valeur prédéterminée pendant le fonctionnement dudit démarreur.

3. Dispositif de détection de l'état d'une batterie selon la revendication 2, **caractérisé en ce que** lesdits moyens (9g) de détermination de la capacité initiale comparent la première capacité de la batterie, qui est détectée lorsque le moteur démarre à l'instant présent, à ladite seconde capacité de la batterie lorsque le moteur s'est arrêté à l'instant précédent en raison de l'interruption du fonctionnement du moteur.

4. Dispositif de détection de l'état d'une batterie selon la revendication 3, **caractérisé en ce que** il comporte en outre des moyens de réglage d'une valeur de consigne servant à régler une valeur de consigne de la charge de la batterie (1) après que le moteur (2) a démarré et en correspondance avec la capacité initiale déterminée par les moyens (9g) de détermination de la capacité initiale dudit dispositif de détection de l'état de la batterie, et des moyens de commande de production pour commander une énergie produite par l'alternateur (5) pour le véhicule de telle sorte que ladite batterie est chargée à la vitesse de consigne réglée par lesdits moyens de réglage de la valeur de consigne.

5. Dispositif de détection de l'état d'une batterie selon la revendication 4, **caractérisé en ce que** lesdits moyens de réglage de la valeur de consigne ajoutent à ladite capacité initiale une valeur d'augmentation (A) de manière à obtenir la valeur de consigne, ladite valeur d'augmentation dépendant de ladite capacité initiale.

6. Dispositif de détection de l'état d'une batterie selon la revendication 5, **caractérisé en ce que** la condition de la batterie (1) est subdivisée en une pluralité de conditions de sa capacité de charge, et lesdits moyens (9g) de réglage de la capacité initiale règlent la valeur d'accroissement à une valeur prédéterminée correspondant à l'une respective de ladite pluralité de conditions.

**7.** Dispositif de détection de l'état d'une batterie selon la revendication 5, **caractérisé en ce que**

lorsqu'une évaluation est faite indiquant que la seconde capacité de la batterie est supérieure à la première capacité de la batterie par comparaison de ladite première capacité de la batterie à ladite seconde capacité de la batterie, lesdits moyens dé réglage de la valeur de consigne soustraient une valeur de correction de ladite valeur d'augmentation et ajoute la valeur résultante à ladite capacité initiale pour obtenir la valeur de consigne.

**8.** Dispositif de détection de l'état d'une batterie selon la revendication 7, **caractérisé en ce que**

ladite valeur de correction est réglée d'une manière directement proportionnelle à une différence entre ladite première capacité de la batterie et ladite seconde capacité de la batterie.

**9.** Dispositif de détection de l'état d'une batterie selon la revendication 4, **caractérisé en ce que**

lesdits moyens de réglage de la valeur de consigne détectent, en tant que capacité de charge non valable, une valeur d'une différence entre les première et seconde capacités de la batterie lorsque la seconde capacité de la batterie est supérieure à une première capacité de la batterie lors de la comparaison desdites première et seconde capacités de la batterie, et en réponse à la capacité de charge non valable détectée de la valeur de différence, règlent une valeur de charge de consigne de la charge de la batterie (1) après le démarrage du fonctionnement du moteur, et

des moyens de commande de l'alternateur sont prévus pour commander la puissance délivrée par ledit alternateur pour le véhicule de telle sorte que ladite batterie est chargée à la valeur de consigne par lesdits moyens de réglage de la valeur de consigne.

**10.** Dispositif de détection de l'état d'une batterie selon la revendication 9, **caractérisé en ce que**

lesdits moyens de réglage de la valeur de consigne soustraient ladite capacité de charge non valable d'une valeur maximale de la seconde capacité de la batterie juste avant que ladite première capacité de la batterie soit détectée pour l'obtention de la valeur de consigne.

**11.** Dispositif de détection de l'état d'une batterie selon la revendication 9, **caractérisé en ce que**

lesdits moyens de réglage de la valeur de consigne règlent en tant que valeur de consigne à un instant actuel une valeur de consigne réglée à un instant précédent lors de la détection d'un zéro en tant que capacité de charge non valable de la valeur de différence.

**12.** Dispositif de détection de l'état d'une batterie selon la revendication 9, **caractérisé en ce que**

lesdits moyens de réglage de la valeur de consigne règlent une valeur de consigne de l'instant présent en ajoutant une valeur prédéterminée à une valeur de consigne de l'instant précédent en réponse à la détection de la capacité de charge non valable de la valeur de différence égale à zéro et en réponse à la détection d'une valeur maximale de la seconde capacité de la batterie, laquelle valeur maximale a été détectée à un instant se situant juste avant la détection de ladite première capacité de la batterie et laquelle valeur maximale est supérieure à la valeur de consigne de l'instant précédent.

**13.** Dispositif de détection de l'état d'une batterie selon la revendication 4, **caractérisé en ce que**

lorsque ladite seconde capacité de la batterie est supérieure à ladite première capacité de la batterie, une différence entre lesdites première et seconde capacités de la batterie est détectée en tant que capacité de charge non valable.

**14.** Dispositif de détection de l'état d'une batterie selon la revendication 4 ou 9, **caractérisé en ce que**

lesdits moyens de réglage de la valeur de consigne modifient ladite valeur de consigne pour la régler sur une valeur de consigne plus élevée alors que le véhicule est conduit dans une condition de décélération ou une condition de descente.

**15.** Dispositif de détection de l'état d'une batterie selon l'une quelconque des revendications 1, 2 et 3, **caractérisé en ce que**

lesdits moyens (9a) de détection du courant de la batterie comprennent :

un noyau magnétique (801) possédant un entrefer (811);
un premier enroulement (803) enroulé sur le noyau magnétique (801) et une ligne omnibus (802) raccordée à une borne de la batterie (1) et couplée magnétiquement au noyau magnétique (801);
un capteur magnétique (804) disposé dans l'interstice pour produire un signal de sortie en réponse au flux magnétique produit dans le noyau magnétique (801);

un second enroulement (805) couplé magnétiquement au noyau magnétique (801), dans lequel un courant de polarisation prédéterminé circule; et

un dispositif (806) de commande d'équilibre magnétique pour amener un courant d'équilibre à circuler dans le premier enroulement (803), ledit courant d'équilibre possédant une amplitude apte à produire un flux magnétique de manière à annuler des flux magnétiques produits par des courants de charge/décharge de la batterie (1) circulant dans la ligne formant bus (802) et également par ledit courant de polarisation prédéterminé, ce qui a pour effet que la valeur du courant circulant dans la ligne omnibus (802) est obtenue sur la base de l'amplitude de ce courant d'équilibre.

**16.** Procédé pour détecter un état d'une batterie comprenant :

une étape de détection du courant de la batterie pour détecter des courants de charge/décharge de la batterie (1),

une étape de détection de la tension de la batterie pour détecter une tension aux bornes de la batterie (1),

une étape d'accumulation du courant de la batterie pour délivrer une valeur cumulée des courants de charge/décharge de ladite batterie, qui ont été détectés par ladite étape de détection du courant de la batterie, et

une première étape de détection d'une première capacité de la batterie pour détecter une première capacité de la batterie sur la base de ladite tension détectée par ladite étape de détection de la tension de la batterie dans des conditions de fonctionnement prédéterminées,

**caractérisé en ce que**

ladite première étape de détection de ladite première capacité de la batterie détecte ladite première capacité de la batterie sur la base de ladite tension qui est détectée par ladite étape de détection de la tension de la batterie dans lesdites conditions de fonctionnement prédéterminées représentées par l'instant d'application d'une charge électrique qui prélève un courant de décharge de ladite batterie (1) détecté par ladite étape de détection du courant de la batterie et possède une amplitude supérieure à une valeur prédéterminée,

une étape de détermination de capacité initiale est prévue pour déterminer une capacité initiale de la batterie (1) sur la base de la première capacité de la batterie détectée par ladite première étape de détection de la capacité de la batterie,

une étape de détection d'une seconde capacité de la batterie est prévue pour ajouter ladite valeur cumulée du courant de la batterie, qui est déterminée après la détection de la première capacité de la batterie et qui a été cumulée par ladite étape d'accumulation du courant de la batterie réglée sur ladite capacité initiale déterminée par ladite étape de détermination de la capacité initiale, la valeur résultante de l'addition étant déterminée en tant que seconde capacité de la batterie, et

ladite étape de détermination de la capacité initiale compare la première capacité de la batterie détectée à l'instant présent à la seconde capacité de la batterie détectée avant la détection de cette première capacité de la batterie, cette seconde capacité de la batterie étant détectée lorsque le moteur s'est arrêté à l'instant précédent en raison de l'interruption du fonctionnement du moteur, et la capacité plus petite de la batterie pour le moteur est déterminée en tant que capacité initiale de la batterie (1).

**17.** Procédé selon la revendication 16, **caractérisé en ce**
**qu'**il comporte l'étape de détection d'une température de la batterie par des moyens (7) de détection de la température de la batterie et de correction de la tension détectée de la batterie sur la base de la température détectée des moyens (7) de détection de la température de la batterie.

**18.** Procédé selon la revendication 16, **caractérisé en ce**
**qu'**il comprend l'étape de détection d'une durée de la batterie après le démarrage de la décharge de la batterie jusqu'à ce que ladite tension soit détectée par les moyens (9c) de détection de la tension de la batterie, et de correction de la tension détectée de la batterie lors de l'achèvement dudit intervalle de temps.

F I G. 1

# FIG. 2

EP 0 464 748 B1

# F I G. 3

START — 20

MEASUE DISCHARGE CHARACTERISTIC WHEN STARTER STARTS — 30

CALCULATE BATTERY CAPACITY VI1 BASED ON DISCHARGE CHARACTERISTIC — 40

READ ACCUMULATED BATTERY CAPACITY VI3 DURING PRERIOUS DRIVE — 50

SET SMALLER CAPACITY AMONG VI1, VI3 AS TRUE VALUE VI4 OF BATTERY CAPACITY — 60

SET CHARGE TARGET VALUE VI0 — 70

MEASURE VB2, IB2, TB2 — 80

CALCULATE
$VI2 = VI2 + \Sigma IB2$ — 90

CONTROL ALTERNATOR — 100

WARNING LOW-BATTERY BASED ON VI2, VI0 — 110

HAVE 10 ms ELAPSED — 170    NO

YES

IS KEY SWITCH TURNED OFF ? — 120    NO

YES

$VI3 \leftarrow VI2$ — 130

END — 140

FIG. 4

BATTERY VOLTAGE

(CONSTANT BATTERY CURRENT)

BATTERY CAPACITY

FIG. 5

CHARGING EFFICIENCY

NEW PRODUCT

DETERIORATED PRODUCT

BATTERY CAPACITY

FIG. 6

CURRENT ACCUMULATION AMOUNT

DETERIORATED PRODUCT

NEW PRODUCT

BATTERY CAPACITY

FIG. 7

BATTERY CAPACITY

FULL CHARGE ZONE

GOOD CHARGE ZONE

NO GOOD CHARGE ZONE

DANGEROUS ZONE FOR BATTERY CHARGE

# F I G. 8

START —301

READ BATTERY CURRENT $I_{BI}$ —302

303
$I_{BI} > 100A$
NO
YES

WAIT FOR 50ms —304

READ $I_{BI}$ —305

306
$60A < I_{BI} < 250A$
NO
YES —307

READ BATTERY VOLTAGE $V_{BI}$ —307

STORE DATA $I_{BI}, V_{BI}, t$ —308

309
$t > 3S$
YES
NO

CALCULATE DATA $I_{Bmax}$, $V_{Imax}, t_{Imax}$ WHEN $I_{BI}$ IS AT MAXIMUM VALUE —310

CALCULATE DATA $I_{Bmin}$, $V_{Imin}, t_{Imin}$ WHEN $I_{BI}$ IS AT MINIMUM VALUE —311

CALCULATE $V_{Bd1}, t_d$ WHEN PREDETERMINED DISCHARGE CURRENT FLOWS —312

END —313

# F I G. 9

```
        ┌──────────────┐
        │    START     │──── 401
        └──────────────┘
               │
               ▼
    ┌────────────────────┐
    │   TIME – CORRECT   │──── 402
    │   VBdl : VBd2      │
    └────────────────────┘
               │
               ▼
    ┌────────────────────┐
    │    READ  TB        │──── 403
    └────────────────────┘
               │
               ▼
    ┌────────────────────┐
    │TEMPERATURE-CORRECT │──── 404
    │    VBd2            │
    └────────────────────┘
               │
               ▼
    ┌──────────────────────────┐
    │OBTAIN BATTERY CAPACI-     │
    │TY VIı CORESPONDING        │──── 405
    │TO VBd3                    │
    └──────────────────────────┘
               │
               ○
               ▼
        ┌──────────────┐
        │   E N D      │──── 406
        └──────────────┘
```

# F I G. 10

EP 0 464 748 B1

5

9f

5c

5b

5a

9f2

9f1

BATTERY
CURRENT
DETECTING
UNIT

BATTERY
VOLTAGE
DETECTING
UNIT

CONDUCTION
RATIO
CONTROL
CIRCUIT

9f3

9f5

CONTROL
CHARGE /
DISCHARGE
VOLTAGE
DETERMIN-
ING CIRCUIT

BATTERY
TEMPERATURE
DETECTING
UNIT

BATTERY
CAPACITY
MONITOR UNIT

ENGINE CONDI-
TION DETECTING
UNIT

9f4

CONTROL
CHARGE /
DISCHARGE
CURRENT
DETERMIN-
ING CIRCUIT

BATTERY
CAPACITY
MONITOR UNIT

ENGINE
CONDITION
DETECTING
UNIT

# F I G. 11

```
           ┌─────────┐
           │  START  │──── 100a
           └─────────┘
                │
                ▼
          100b ╱╲
     YES   ╱      ╲
    ◄─────╱ I_B2>I_BC ╲
         ╲         ╱
          ╲      ╱
            ╲  ╱
             │ NO
             ▼
100c                    100d
┌───────────────┐  ┌───────────────┐
│ T_ON=T_ON-Δβ2 │  │ T_ON=T_ON+Δβ1 │──── 100d
└───────────────┘  └───────────────┘
        │                │
        └────────┬───────┘
                 ○
                 │
                 ▼
            100e ╱╲
           ╱      ╲      YES        100f
          ╱ V_B2>V_BC ╲─────────┐
          ╲          ╱          │
           ╲        ╱     ┌───────────┐
             ╲    ╱       │  T_ON = 0 │
              │ NO        └───────────┘
              ○◄───────────────┘
              │
              ▼
         ┌──────────┐
         │  RETURN  │──── 100h
         └──────────┘
```

# F I G. 12

START — 100i

IS LOAD SUDDEN-LY-INCREASE CONTROL ? — 100j — YES

NO

$|I_{B2} - I_{BC}| > I_0$ — 100k — YES

NO

YES — $I_{B2} = I_{BC}$ — 100m

NO

NORMAL CONTROL — 100ℓ

LOAD SUDDENLY-INCREASE CONTROL — 100n

IS LOAD SUDDEN-LY-INCREASE CON-TROL ? — 100o — YES

NO — 100q

$T_{ON} = T_{ON} - \Delta\alpha 2$ — 100q

$T_{ON} = T_{ON} + \Delta\alpha 1$ — 100p

$T_{ON}$ : ON TIME OF TRANSISTOR 9f1

$V_{B2} > V_{BC}$ — 100r — YES

NO

$T_{ON} = 0$ — 100s

RETURN — 100u

# F I G. 13

```
                    ┌─────────────┐
                    │    START    │~500
                    └──────┬──────┘
                           │
                    ╱──────────────╲
                   │ INPUT ENGINE   │~501
                   │ CONDITION      │
                   │ SIGNAL         │
                    ╲──────────────╱
                           │
                        ◇ IS ◇ ~502
          YES        VEHICLE
     ┌─────────── UNDER ACCELERA-
     │            TION CONDI-
     │               TION ?
     │                   │ NO
  ◇ 503 ◇                │
 IS SECOND BATTERY    ◇ IS ◇ ~506
 CAPACITY VI₂ ENTERED   VEHICLE
 INTO FULL CHARGE OR  UNDER DECELER-      YES
 GOOD CHARGE ZONE ? ─NO─ ATION CONDITION ────────────┐
     │                   ?                            │
     │ YES              (DOWN HILL)                   │
     │  504                │ NO           YES    ◇ 507 ◇
┌──────────────┐           ○ ◄──────────────── IS SECOND BATTERY
│ LOWER VBC BY │           │                   CAPACITY VI₂ ENTERED
│ 2(V) FROM    │           │                   INTO DANGEROUS ZONE
│ NORMAL VALUE │           │                        ?
└──────────────┘           │                        │ NO  508
     │                     │ 511                ┌─────────────┐
┌──────────────┐      ┌──────────────┐         │ VBC = 15(V) │
│ IBC = O (A)  │      │VBC = NORMAL   │         └─────────────┘
└──────────────┘      │      VALUE    │                │  509
     505              └──────────────┘         ┌─────────────┐
                           │ 512              │ IBC = 30(A) │
                      ┌──────────────┐         └─────────────┘
                      │IBC = NORMAL   │                │  510
                      │      VALUE    │         ┌─────────────┐
                      └──────────────┘         │ VIo =       │
                           │ 513              │ NORMAL VALUE │
                      ┌──────────────┐         │ +5(Ah)      │
                      │VIo = NORMAL   │        └─────────────┘
                      │      VALUE    │                │
                      └──────────────┘                │
                           │                          │
     └─────────────────────○──────────────────────────┘
                           │
                    ┌─────────────┐
                    │   RETURN    │
                    └─────────────┘
```

# F I G. 14

START — 20

MEASURE DISCHARGE CHARACTERISTIC WHEN STARTER STARTS — 30

CALCULATE BATTERY CAPACITY $VI_1$ BASED ON DISCHARGE CHARACTERISTIC — 40

READ ACCUMULATED BATTERY CAPACITY $VI_3$ DURING PREVIOUS DRIVE — 50

SET SMALLER VALUE AMONG $VI_1$, $VI_3$ AS TRUE VALUE $VI_4$ OF BATTERY CAPACITY — 60

SET CHARGE TARGET VALUE $VI_0$ — 70

$VI_2 \leftarrow VI_4$, $PSOC \leftarrow VI_4$ — 150

MEASURE $V_{B2}$, $I_{B2}$, $T_{B2}$ — 80

CALCULATE $VI_2 = VI_2 + \Sigma I_{B2}$ — 90

STORE MAXIMUM VALUE OF $VI_2$ INTO PSOC — 160

CONTROL ALTERNATOR — 100

WARNING LOW BATTERY BASED ON $VI_2$, $VI_0$ — 110

HAVE 10ms ELAPSED ? — 170 — NO — YES

IS KEY SWITCH TURNED OFF ? — 120 — NO — YES

$VI_3 \leftarrow VI_2$, $PSOCB \leftarrow PSOC$ $TSOCB \leftarrow TSOC$ — 130

END — 140

# F I G. 15

START

700 — IS BACK-UP DATA OK ?

NO →

YES

701 — SET VI3 - VI4 TO PRESENT GSOC

702 — GSOC = 0

YES →

NO

703 — PREVIOUS TSOC ≦ PREVIOUS PSOC

YES →

NO

704 — SET ( PREVIOUS PSOC - PREVIOUS GSOC ) TO PRESENT TSOC

705 — SET PREVIOUS TSOC TO PRESENT TSOC

706 — SET ( PREVIOUS TSOC + γ ) TO PRESENT TSOC

707 — SET RATED CAPACITY TO PRESENT TSOC

END

EP 0 464 748 B1

# F I G. 16

# F I G. 17

MAXIMUM CAPACITY DURING
BATTERY DETERIORATION

# F I G. 18

F I G. 19

EP 0 464 748 B1

F I G. 20

VOUT (V)

-150        -100        -50        O        50        100        150   CURRENT I (A)

(CHARGE)                                    (DISCHARGE)

F I G. 21

VOUT (V)

O        50        100        150        200   CURRENT I (A)

(DISCHARGE)

F I G. 22

EP 0 464 748 B1